(19) Europäisches Patentamt
European Patent Office
Office européen des brevets

(11) **EP 3 220 821 B1**

(12) **EUROPEAN PATENT SPECIFICATION**

(45) Date of publication and mention
of the grant of the patent:
**03.11.2021 Bulletin 2021/44**

(51) Int Cl.:
*A61B 5/12* *(2006.01)*       *H03G 3/32* *(2006.01)*
*A61F 11/06* *(2006.01)*      *H03G 9/02* *(2006.01)*
*H04R 1/10* *(2006.01)*       *H04R 29/00* *(2006.01)*

(21) Application number: **15801486.0**

(22) Date of filing: **18.11.2015**

(86) International application number:
**PCT/GB2015/053508**

(87) International publication number:
**WO 2016/079513 (26.05.2016 Gazette 2016/21)**

(54) **PORTABLE PROGRAMMABLE DEVICE, SYSTEM, METHOD AND COMPUTER PROGRAM PRODUCT**

TRAGBARE PROGRAMMIERBARE VORRICHTUNG, SYSTEM, VERFAHREN UND COMPUTERPROGRAMMPRODUKT

DISPOSITIF PROGRAMMABLE PORTABLE, SYSTÈME, PROCÉDÉ ET PRODUIT-PROGRAMME D'ORDINATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.11.2014 GB 201420456**
**18.11.2014 GB 201420461**
**07.01.2015 GB 201500180**
**17.06.2015 GB 201510643**

(43) Date of publication of application:
**27.09.2017 Bulletin 2017/39**

(73) Proprietor: **Limitear Limited**
**London W7 2QE (GB)**

(72) Inventors:
• **WHEATLEY, Stephen**
**Greater London W7 2QE (GB)**
• **GLOVER, Richard**
**Greater London W7 2QE (GB)**
• **BLINCOE, Steve**
**Greater London W7 2QE (GB)**

(74) Representative: **Langley, Peter James**
**Origin Limited**
**Twisden Works**
**Twisden Road**
**London NW5 1DN (GB)**

(56) References cited:
**EP-A1- 2 675 187       US-A1- 2008 130 906**
**US-A1- 2009 315 708    US-A1- 2010 027 807**
**US-A1- 2010 046 767    US-A1- 2012 057 726**
**US-A1- 2014 270 254**

• **GERALD KAISER: "Gateway to wavelets", IEEE POTENTIALS, IEEE, NEW YORK, NY, US, vol. 17, no. 2, 1 April 1998 (1998-04-01), pages 34-37, XP011088829, ISSN: 0278-6648**

**Description**

**BACKGROUND OF THE INVENTION**

1. Field of the Invention

The field of the invention relates to portable programmable devices configured to adjust audio output in order to avoid user noise induced hearing loss. The field of the invention further relates in one aspect to non-automatic-control options, such as presenting hearing dose data in a suitable form to the user to enable the user to take intelligent action. The field of the invention also relates to related systems, methods and computer program products.

2. Technical Background

It has been established for many years that hearing can be permanently impaired through prolonged exposure to high sound intensity, or by short bursts of extremely high intensity. The effect being accumulative, irreversible hearing impairment may not be detected for many years after exposure. This makes the assessment and control of sound pressure levels very important for both the workplace and more general situations.

Guidelines and regulations have been improved as the understanding of the effects of sound exposure have developed. Acceptable noise exposure levels have been generally reduced and the scope of application has broadened. Legislation to control noise in the workplace is common in many countries and has encouraged employers and employees to re-appraise exposure to damaging sound pressure levels. Such noise exposure legislation is directed towards limiting both short-term peak levels, and dose or long-term averaged levels. There are also some attempts to establish effective regulation of noise-exposure during recreational use, such as IEC62368-2.

Earpiece users are subject to noise from both the earpiece (reproduced sound) and local environment (ambient noise); thus several approaches to hearing protection may be necessary. Ambient noise levels can be suppressed at source, and this approach is usually emphasized in noise-exposure legislation and guidance. Additional ambient noise suppression can utilise better-isolating earpieces such as "over-the ears" headsets or "in-ear monitors" (IEM), or through the various forms of noise-cancelling earpiece system. Note: In this document, "earpieces" is used generically to include headphones, headsets, in-ear monitors, ear-buds and similar devices.

Clear communication or listening generally necessitates earpiece generated acoustic levels to exceed those reaching the ears from the ambient. The relative levels will depend on the respective characteristics of signal and ambient. Where the ambient noise levels have been brought into reasonable control, earpiece-generated sound will typically dominate the noise exposure.

Various techniques are used to restrict the acoustic levels generated by the earpieces. These include electrical source-limiting, electrical or mechanical limiting techniques at the earpieces, and in-line limiting devices controlling the electrical signals. In situations where significant ambient levels still reach the ears, many of these limiting techniques do not allow short-term high-levels through the earpieces and so compromise communication intelligibility.

Noise-exposure legislation generally applies to the workplace and is based on clearly understood guidelines for safe hearing levels. Relatively high levels can be tolerated for short periods whereas somewhat lower levels can be tolerated indefinitely. There is frequency dependency to this, with lower and higher frequencies being less harmful than mid-range frequencies. For longer-term noise exposure, an A-weighted frequency characteristic is taken to be a good representation of the relative susceptibility to damage. To deliver the highest safe acoustic levels, these factors need to be taken in into account in any noise-management scheme.

At the present time most countries have little effective legislation pertaining to noise induced hearing loss (NIHL) outside the workplace environment. Yet the widespread use of personal listening devices has led to increasing concerns about hearing damage from prolonged use. Some manufacturers have introduced primitive level-restricting schemes in SmartPhones and similar devices to address these concerns. In some countries, notably France, legislation places restrictions on the level a portable electronic device such as an MP3 player can deliver, and on the sensitivity of earpieces. Taken in combination, these would constrain the delivered acoustic levels in some situations.

There are a significant variety of earpiece sensitivities and impedances, and a wide range of source signal levels. Earpiece sensitivity is often quoted in terms of the sound pressure level (SPL) measured under defined conditions delivered from a particular electrical input. Towards the lower end of sensitivity range would be 90dBA SPL per mW of 1 KHz sinusoid. Another earpiece such as a sensitive IEM could deliver more than 110dBA SPL from the same signal. A range of earpiece sensitivities exceeding 20dB can be achieved. Many of these earpieces share common connectors such as the 3.5mm jack/phono style. Typically a 3dB change in exposure relates to a doubling or halving of exposure time to achieve the same dose. 20dB difference in sensitivity implies that whereas one earpiece is safe for a period of 8 hours in a day, limits will be exceeded with a 20dB more sensitive earpiece in only 5 minutes.

Comparing earpieces using a sensitivity representation of dBA SPL per volt, an even greater range is observed, and this pertains particularly to the common situation where the source device (such as a smart phone) has relatively low output impedance compared with the earpiece.

Some source devices (such as a smart phone) have a maximum output level of less than 800mV peak-to-peak; others (e.g. a typical sound card) could exceed 4 times this (>12dB), and others significantly higher again.

Noise-induced hearing loss (NIHL) may be significantly reduced from the likely outcome of today's often excessive hearing-dose levels if suitable information were available to users of headsets, or if automatic hearing dose level devices were used.

With the expanding use of wireless hearing devices such as WiFi or Bluetooth-Smart connected headsets and earpieces, cable-based solutions are not applicable to these wireless devices; source-device solutions may be ineffective as there is a wide range of hearing devices (headsets, earpieces etc) that can be connected, and these can have very different characteristics such as sensitivity. The headset or earpiece may also include some means of altering volume rendering source-based solutions ineffective. Professional users are required to abide by hearing-dose regulation, but at present non-professional users do not have to. However, all users could be helped with better information about the hearing-dose levels their ears are being subjected to.

An aim relating to this disclosure is to facilitate access to hearing dose data so that users can take informed decisions on their hearing levels, or can elect to allow an automatic level control system to operate. This may be implemented at a low cost across a wide range of platforms and devices.

3. Discussion of Related Art

In practice, audibility of the reproduced sound demands that earpiece-generated levels at the ear exceed leakage from ambient noise. However, user-comfort often demands some level of ambient sound is heard. Where ambient leakage plays a significant part in hearing dose, prior art US2008137873(A1) discloses an earpiece is provided that can include an Ambient Sound Microphone to measure ambient sound, an Ear Canal Receiver to deliver audio to an ear canal, an Ear Canal Microphone to measure a sound pressure level within the ear canal, and a processor to produce the audio from at least in part the ambient sound, actively monitor a sound exposure level inside the ear canal, and adjust a level of the audio to within a safe and subjectively optimized listening level range based on the sound exposure level.

For most earpiece users, reproduced sound levels are adjusted by the user for audibility over moderate levels of ambient noise leakage, and earpiece-generated sound will typically dominate the noise exposure. Simple earpieces are used for non-specific periods of time. Personal earpieces may be used during recreation or on journeys between home and work, and a professional earpiece may be used during the day. Exposure to ambient noise can also contribute to daily noise dose, but people do not generally carry noise-dosimeters to measure their noise exposure.

US20100027807A1 discloses techniques and apparatus for limiting a sound pressure level produced by an audio output device driven by an audio player. During play, the audio player monitors the current sound pressure level of the audio output device, and in response thereto limits the sound pressure level by controlling an output level of audio signals it generates so as to reduce hearing loss caused by excess volume.

US20090315708A1 discloses aspects of a method and system for limiting an audio signal output in an audio device. An exposure meter may provide measurements of SPL values of the audio signal. When a volume or exposure level of the audio signal may approach or exceed a specified limit, the audio signal may be enforced to a predetermined limit. The audio signal may be an input or an output signal of a speaker of an audio device such as a stereo headset.

US20120051555A1 discloses a method for adjusting volume in a headset based on accumulated acoustic energy density exposure. A sound pressure value of a microphone positioned in a user's ear canal is measured. A current accumulated acoustic energy density exposure is determined based on sound pressure values measured during the rolling window.

US20120057726A1 discloses a system and method for automatically limiting the sound exposure incurred by users of sound reproducing devices, by continuously tracking and evaluating the cumulative sound exposure dose. Instead of limiting the average sound level to a fixed maximum, the user retains freedom to adjust the sound volume to higher or lower levels.

WO2008136723A1 discloses a method for limiting the sound volume in an earphone, a headset, or the like, to a maximum permitted level, in which an input signal is sensed by a processor and damped by a damper if it is excessively high. Thereafter, the signal is transmitted to the earphone, the headset, or the like. The processor switches between an active mode and a rest mode. An apparatus for limiting the sound volume according to the method includes a microprocessor and a damper.

WO2011050401A1 discloses a noise induced hearing loss management system and method which enables an individual's exposure to noise to be measured, logged and displayed. Sound data can be collected by means of noise dosimeters preferably attached to hearing protection devices which can measure noise levels experienced by the wearer of the hearing protection device as well as ambient noise levels. Information about this exposure as sound data can be logged and stored on storage devices thus maintaining a history of an individual's exposure to noise over a predetermined period of time and particular over an individual's working lifetime.

US20070274531A1 discloses a method and apparatus for automatically adjusting the volume of a headset. The headset includes a speaker and a pressure transducer. The speaker projects audible signals into the ear canal, while the pressure transducer measures a sound pressure level in the ear canal. Based on the measured sound pressure level, a control system controls the volume of the audible sound projected from the speaker.

US20080181424A1 discloses an audio processor device and method which measures and provides information relating to the audio level being applied to the ear of a user. The processor device uses a preset or calibrated sensitivity of the applied earphones in combination with an analysis of the audio stream to provide sound-pressure-level or time-weighted exposure information to the user or limit the output when preset levels have been achieved.

US20080130906A1 discloses methods and devices for hearing damage notification and intervention.

## SUMMARY OF THE INVENTION

Aspects of this invention are applicable to most situations where the use of earpieces, headphones and similar could lead to noise-induced-hearing-loss (NIHL). An aim is to establish safe-hearing levels whilst allowing users to change earpieces, change what they are connected to, and account for how long they listen. An important principle is the avoidance of sophisticated hearing devices, making the best use of standard earpieces of various characteristics. Aspects of this invention may embrace wired and/or wireless earpiece configurations, and extend to web-based facilities for coordination and may embrace work and/or recreational use.

Aspects of this invention provide the user with the best available information about their risk to NIHL from accumulated noise-dose. Aspects of this invention adapt to different configurations and equipment being used and accept key parameters from a variety of sources. Aspects of this invention aim to work with standard earpieces, use of earpieces over the day in different source devices, account for different listening periods and the full range of programme content. Aspects of this invention facilitate earpiece calibration where this is able to improve dose estimation. Aspects of this invention facilitate automatic control of hearing level and allow for dose-data and generic information to be distributed.

Aspects of this invention provide the user with the ability to incorporate ambient contributions to noise-dose, such as through self-assessment based on certain hours per day of various activities such as noise of train journeys, clubs etc, both with and without noise protection devices. Such augmentations of noise-dose records improve the overall accuracy of noise dose recordation.

According to a first aspect of the invention, there is provided a portable programmable device including a battery, a memory, a screen and a terminal connectable to earpieces, wherein the device is configured to prompt the user to identify the earpieces when the earpieces are connected to the device, the device including in the memory a calibration file, parameter or parameters relating to audio sensitivity of the earpieces, the device being configured to play media data including audio, and to provide audio output to the earpieces, the device being further configured to, using the calibration file, parameter or parameters, calculate a noise dose relating to a sound exposure of a user resulting from audio output provided to the earpieces, and to record the noise dose on the device, wherein the device is configured to adjust audio output level in response to:

(a) audio content included in played media data;
(b) the calibration file, parameter or parameters, and
(c) noise dose data of the user recorded on the device;

wherein the device is configured to calculate the noise dose using subsampling from signals going to the earpieces.

An advantage is that the device is able to provide safe levels of audio output to the earpieces, thereby protecting the hearing of the user, because the device audio output is responsive to (a) audio content included in played media data, (b) the calibration file, parameter or parameters and (c) noise dose data of the user recorded on the device. However, the levels of audio output to the earpieces are not necessarily too safe, which might degrade the listener's experience.

Media data may be an audio file or a video file including audio, or output from a computer game including audio output, or audio data from a phone call, for example.

The device may be configured to adjust audio output level so as to reduce audio output to safe levels for the user. An advantage is protecting the hearing of the user.

The device may be configured to adjust audio output level so as to ensure that a safety margin is always available. An advantage is protecting the hearing of the user, with a safety margin for example in case of sudden noise exposure, or previously unrecorded noise exposure.

The device may be further configured to adjust audio output level in response to a comparison of the noise dose with regulatory or recommended safe levels. An advantage is automated compliance with regulatory or recommended safe levels.

The device may be further configured to adjust audio output level in response to a measure of ambient noise recorded using a microphone of the portable programmable device. An advantage is that significant ambient noise is taken into consideration, which reduces the chance of a safety risk because the user is not able to hear the intended audio output. The device is one wherein the noise dose is calculated using subsampling. An advantage is energy-efficient calculation of noise dose.

The device may be one wherein the noise dose is calculated including using a measure of ambient noise recorded using a microphone of the portable programmable device. An advantage is that significant ambient noise is taken into consideration when calculating the noise dose.

The device may be one wherein the noise dose is calculated using audio output volume, a measure of the relationship between the audio output level and energy, and duration. An advantage is that more complex aspects of audio output can be factored into noise dose calculation.

The device may be one wherein a recorded noise dose is tagged with an uncertainty code representing how the estimation may deviate from full noise-dose estimation.

The device may be one wherein the noise dose data of the user recorded on the device includes noise dose data relating to the user, received from a web server. An advantage is that a user noise dose history may be used when adjusting audio output.

The device may be one wherein the noise dose data of the user recorded on the device includes noise dose data relating to the user, provided by a user self-assessment. An advantage is that noise dose data that would otherwise have been unrecorded can be included in the noise dose data.

The device may be one wherein the device is connectable to a plurality of different earpieces, the device including a plurality of calibration files or parameters corresponding to respective earpieces, in which the calibration file or parameters used to adjust the audio output correspond to the earpieces. An advantage is that when adjusting audio output, the adjustment may be performed for the correct earpieces, which may have very different audio characteristics to some other earpieces.

The device may be one wherein the devices and the earpieces are configured to communicate with each other, and the device is configured to identify the earpieces when the earpieces are connected to the device. Any technique may be used, such as NFC (near field communication). An advantage is automated detection of the type of earpieces.

The device may be one wherein the earpieces are identifiable on the device by manually entering a unique identity of the earpieces on the device.

The device may be one wherein the earpieces are identifiable on the device by scanning an optical barcode of the earpieces, such as by scanning product packaging or similar, such as a guarantee card, using a camera included in the portable programmable device. An advantage is convenient identification of the earpieces type.

The device may be one wherein the optical barcode is a QR code.

The device may be one wherein the devices and the earpieces are configured to communicate with each other, and the device is configured to receive the calibration file, parameter or parameters when the earpieces are connected to the device. Any technique may be used, such as NFC (near field communication). An advantage is automated detection of the calibration file, parameter or parameters.

The device may be one wherein the device prompts the user to provide the calibration file, parameter or parameters when earpieces are connected to the device.

The device may be one wherein calibration data of the earpieces are receivable on the device by manually entering the calibration file, parameter or parameters of the earpieces on the device.

The device may be one wherein the calibration file, parameter or parameters of the earpieces are receivable on the device by scanning an optical barcode of the calibration file, parameter or parameters, such as by scanning product packaging or similar, such as a guarantee card, using a camera included in the portable programmable device. An advantage is convenience.

The device may be one wherein the optical barcode is a QR code.

The device may be one wherein the memory is a non-volatile memory.

The device may be one wherein the media data includes media files which are stored in the memory.

The device may be one wherein the terminal is a physical connector.

The device may be one wherein the terminal is a wireless terminal, connectable wirelessly to the earpieces which are wireless earpieces.

The device may be one wherein the device is configured to receive settings information from the wireless earpieces and to adjust audio output as a function of audio frequency in response to the received settings information. An advantage is that settings such as a local volume control can be factored into the adjustment of audio output.

The device may be one wherein the adjustment of audio output level is an adjustment of audio output level as a function of audio frequency. An advantage is that frequency dependent adjustment of the output level can optimise intelligibility versus noise-dose.

The device may be one wherein the device is configured to provide user noise dose data using an internet connection to a website including an account relating to an accumulated noise exposure of the user. An advantage is that user noise exposure data may be accumulated across user devices.

The device may be one wherein the device includes a screen. The device may be one wherein the device is configured to present on the screen a hearing-dose-level indication to the user. The device may be one wherein the device is configured to present on the screen an estimate of the likely hearing loss at a given future date or user age based on recorded user noise dose.

The device may be one wherein the device is configured to demonstrate the likely effect of hearing loss on hearing quality, in response to a touch of a (eg. soft) button.

The device may be one wherein the device includes a setting selectable to provide automatic hearing-dose-management.

The device may be one wherein the device includes a main communications and processing unit which includes an audio output.

The device may be one wherein the device is able to monitor and integrate noise-exposure over long periods (e.g. 24 hours).

The device may be one wherein the device is configured such that shorter term noise exposures are controlled to not exceed one level, and longer-term exposures are controlled to not exceed another, lower level.

The device may be one wherein the device is configured such that a logarithmic approximation process is used to compare the ratio of signal to a threshold, which yields a number proportional to a log ratio, and wherein subsequent response operations are based on dB.

The device may be one wherein the device includes cascaded hearing dose management processing elements, in which there is provided an input sound signal, which is fed to a first cascaded hearing-dose processor which has an output going to a next hearing-dose processor as well as a contributory signal to request attenuation, in which cascaded processes with corresponding contributory attenuation signals combine to form an overall attenuation control signal which attenuates the input signal in a unit to form an output signal.

The device may be a smartphone, a tablet computer, a MP3 player, a laptop computer, or a head mounted display.

According to a second aspect of the invention, there is provided a method of adjusting audio output level on a portable programmable device, the device including a battery, a memory and a terminal connectable to earpieces, the device including in the memory a calibration file, parameter or parameters relating to an audio sensitivity of the earpieces, the device configured to play media data including audio, the method comprising the steps of:

(i) the device prompting the user to identify the earpieces when the earpieces are connected to the device,
(ii) providing audio output to the earpieces,
(iii) calculating using the calibration file, parameter or parameters a noise dose relating to sound exposure of a user resulting from audio output provided to the earpieces, the calculating the noise dose using subsampling from signals going to the earpieces;
(iv) recording the noise dose, and
(v) adjusting audio output level in response to:

(a) audio content included in played media data;
(b) the calibration file, parameter or parameters, and
(c) noise dose data of the user recorded on the device.

An advantage is that the method is able to provide safe levels of audio output to the earpieces, thereby protecting the hearing of the user, because the device audio output is responsive to (a) audio content included in played media data, (b) the calibration file, parameter or parameters, and (c) noise dose data of the user recorded on the device. However, the levels of audio output to the earpieces are not necessarily too safe, which might degrade the listener's experience.

The method may be one wherein the device is a device of any of aspect according to the first aspect of the invention.

The method may include use of cascaded processing elements operating with different timescales.

The method may include a step of a digital signature of played media data being periodically generated and conveyed to an external database for identification.

According to a third aspect of the invention, there is provided a computer program product executable on a portable programmable device, the device including a battery, a memory and a terminal connectable to earpieces, the computer program product executable on the device to adjust audio output level, the device including in the memory a calibration file, parameter or parameters relating to an audio sensitivity of the earpieces, the device configured to play media data including audio, the computer program product executable on the device to:

(i) prompt the user to identify the earpieces when the earpieces are connected to the device,
(ii) provide audio output to the earpieces,
(iii) calculate using the calibration file, parameter or parameters a noise dose relating to sound exposure of a user resulting from audio output provided to the earpieces, the calculating the noise dose using subsampling from signals going to the earpieces;
(iv) record the noise dose, and
(v) adjust audio output level in response to:

(a) audio content included in played media data;
(b) the calibration file, parameter or parameters, and
(c) noise dose data of the user recorded on the device.

The computer program product may be one wherein the device is a device of any of aspect according to the first aspect of the invention.

## BRIEF DESCRIPTION OF THE FIGURES

Aspects of the invention will now be described, by way of example(s), with reference to the following Figures, in which:

**Figure 1** shows an example configuration of a wireless hearing device (1), a portable device (2) and an internet website (5).
**Figure 2** shows an example of detail of a wireless hearing device.
**Figure 3** shows an example configuration of analogue-connected earpiece (321), a plug-in, plug-out unit (320), a smartphone (302) and a website (305).
**Figure 4** shows schematically one possible example of a system including a profile of an individual's hearing exposure recorded on a smartphone, presenting status alerts on a screen of a smartphone, and via a web app, presenting on a computer screen detailed analysis of the individual's hearing exposure and potential risks.
**Figure 5** shows an example of two audio traces.
**Figure 6** shows an example of a sound delivery system of the prior art.
**Figure 7** shows an example of an idealized control device.
**Figure 8** shows an example of a monitoring and control (intermediate) device.
**Figure 9** shows an example of a basic control device.
**Figure 10** shows an example of cascaded hearing dose management processing elements.
**Figure 11** shows an example of further detail of a single HDM processing element reference (102) in **Figure 10.**
**Figure 12** shows an example of detail of the output processing, which illustrates unit (114) in **Figure 10.**

## DETAILED DESCRIPTION

### Introduction

For those situations where reproduced sound in earpieces is a significant part of daily hearing dose, three broad approaches can establish safe listening levels:

- Users can be given information, encouraged and be assumed to act on it.
- The source or earpiece could be level-restricted to constrain instantaneous levels for safe long-term dose.
- An automated level-control scheme can be implemented to adjust levels in accordance with long-term safe noise-dose.

Assisting users to take responsibility for their hearing is likely to contribute to an effective long-term solution. NIHL can take years to develop, and so presentation of live noise-dose information during earpiece use can provide a useful feed-back tool for learning safe hearing levels. This is one aspect of the present disclosure.

Restriction of short-term levels at source or earpiece can ensure long-term dose is safe, but significantly constrains the dynamic range of program material and potentially introduces distortion. This approach would work best when program material has limited dynamic range and listening times are well understood. Otherwise such approaches may be rejected by users as unusable or unnecessarily constraining.

Automatic protection, based on assessment of noise-dose accumulation and comparison with safe levels, ensures short-term listening experience is unimpeded and relatively high levels can safely be accommodated within an overall context of safe-noise-dose.

Noise-exposure legislation generally applies to the workplace and is based on clearly understood guidelines for safe hearing levels. Relatively high levels can be tolerated for short periods whereas somewhat lower levels can be tolerated indefinitely. There is frequency dependency to this, with lower and higher frequencies being less harmful than mid-range frequencies. For longer-term noise exposure, an A-weighted frequency characteristic is taken to be a good representation of the relative susceptibility to damage. To deliver the highest safe acoustic levels, these factors need to be taken into account in a noise-management scheme.

Widespread use of personal listening devices has led to widespread concern about hearing damage from recreational use. Legislative approaches, notably in the EU, have been based on limiting the output levels that a portable electronic device such as an MP3 player can deliver without additional user-intervention, in combination with constraining the sensitivity of earpieces. Attempts are made to define levels for typical program content and typical listening periods. Under ideal conditions, these will constrain the noise-dose from reproduced sound. This has resulted in manufacturers introducing primitive level-restricting schemes in SmartPhones and similar devices. There are many difficulties with such an approach, and these will be considered in terms of earpieces, listening periods, program content and source device.

Most earpieces use the near-universal 3.5mm jack plug, which means that earpieces with vastly differing sensitivities can be connected to a particular source device. This in itself may render any such source-based limitation useless: it could lead to a false sense of security with consequent NIHL. Typically a 3dB change in exposure relates to a doubling or halving of exposure time to achieve the same dose. 20dB difference in sensitivity implies that whereas one earpiece is safe for a period of 8 hours in a day, limits will be exceeded with a 20dB more sensitive earpiece in only 5 minutes.

Earpiece sensitivity is often quoted in terms of the sound pressure level (SPL) measured under defined conditions delivered from a particular electrical input. Towards the lower end of sensitivity range would be 120dBA SPL per V of 1kHz sinusoid. Some earpieces have a deliberately non-flat frequency response; this may affect the 1kHz level for overall safe hearing levels. This is compounded by manufacturer's often poor or ambiguous specification for sensitivity.

Earpieces also feature differing impedances, 32R being common but 10R to 600R being possible. With low impedance source devices, smartphones etc, this is not a concern. However, some source devices do have finite output impedances and so this may affect the actual noise-dose being delivered.

Listening periods may vary widely, such as from a 15 minute walk twice per day to 10 hours of studio work sandwiched by 2 hour train journeys. A scheme that fails to account for noise-dose accumulation rather than a notional fixed-day exposure will in some cases under-protect and in others over-constrain listening levels. The latter leads to rebellion against such schemes when it is vital to gain users acceptance.

The nature of programme content also has significance. For a given maximum such as dictated by any electronic source device, occasional speech of high quality or light piano music will deliver much lower average energy than highly compressed and continuous music as is readily available. The frequency content of program material can also vary, some having more of the relatively harmful frequencies than others. An effective average energy in the more damaging frequency ranges can have little relation to the source device volume setting, introducing more uncertainty in noise-dose exposure in an uncontrolled or poorly controlled case.

A user may connect their earpieces to several different source devices during the course of a day; source devices exhibit a wide range of potential outputs.

All of these factors combine to determine the noise-dose levels delivered over the course of a day. They conspire to increase uncertainty in NIHL being incurred. A comprehensive solution to these issues is addressed by the present disclosure.

Assessment of ongoing contributions to noise-dose in the day's varying circumstance depends on many factors some of which are associated with a level of uncertainty. This disclosure discloses a platform that adapts to the different situations, and presents the best assessment from the information available whilst identifying the areas of uncertainty. Because of the wide range of scenarios any earpiece user may operate in, and the aim of improving protection against NIHL in as many areas as possible, there are several peripheral aspects to the disclosure.

For the use of standard non-specialised earpieces such as those that incorporate ear-canal-microphones, successful assessment of hearing dose from the earpiece relies on assessment of the electrical signal feeding it, but also (importantly) relies on knowledge of its electrical to acoustic conversion. This is commonly referred to as sensitivity, and one aspect of this disclosure is in securing the best information available with minimum user effort.

Where such data on sensitivity is not available, an aspect disclosed in this disclosure is to facilitate calibration of an earpiece to provide improved data. Calibration data may be represented by a single parameter, by a plurality of parameters, or by a calibration file.

Assessing hearing dose delivered by different types of earpiece with different source devices in different environments requires appropriate integration of data across potentially several platforms, another important aspect of this disclosure.

To process the monitored earpiece signals for extraction of meaningful noise-dose data in a wide range of scenarios requires both scalability and flexibility, as provided by this disclosure. Assessing the earpiece feed signals requires significant processing, A-weighted filtering, power-conversion and averaging. Some devices (such as wireless headsets) may not have sufficient resources for this; another aspect of this disclosure is to dynamically make the best use of resources available. In this particular example, full processing may be possible in a smartphone involved in the signal chain feeding the wireless headset, and the latter performs appropriate sampling of the earpiece feed to complement this. In another example, it may be that less than optimum processing is used to assess the contributions to noise-dose; this will contribute some uncertainty to the overall assessment, but can be a significant improvement on what may otherwise occur.

For maximum flexibility of implementation, the processing task needs to be efficient so that it can be undertaken by more of the devices in any particular configuration. Some efficiencies form part of this disclosure.

User protection can be through provision of information, enabling the user to take appropriate action. An aspect of this disclosure is to allow for information to be presented in an appropriate way via an appropriate device, even though its derivation may be performed elsewhere.

User protection can be supported with automatic control of hearing levels, ensuring daily hearing dose is not exceeded and a margin is always available. An aspect of this disclosure is to facilitate assessment of the required control action on one device whilst undertaking the control action in another.

Central to this disclosure is coordination whereby personal noise-dose contributions are gathered to form an integrated assessment, yielding the most appropriate information to a user and data for any level controlling device.

This disclosure provides a benefit that users with standard earpieces and moving between different environments during the day are able to enjoy a greater level of protection from NIHL.

The disclosures of the following sections one to five may be combined, as would be clear to one skilled in the art.

## Section One - Hearing Dose Management for Wireless Headsets

This section relates to hearing dose management for implementation in wireless headsets and other wireless earpieces.

### Problems

Although it is possible to implement some degree of hearing dose management in an electronic source device (smart-phone, MP3 players etc), this necessitates some knowledge of what earpiece is connected to it. With wireless devices using common interfaces such as WiFi, Bluetooth or Bluetooth Smart, there is no direct connection. In these situations, earpieces with very different characteristics may be being connected with a particular sound-source device, and hence any attempt at implementing hearing dose management in the source device is significantly compromised.

Schemes are possible whereby suitable information about earpieces can conveniently be communicated with a hearing dose management scheme embedded or residing in such an electronic source device. See Section Two, for example.

It is also possible to integrate effective hearing dose management in the wireless headset itself. This would ensure a particular user's ears are protected from all sound conveyed by the headset. One example of how this can be achieved with minimal overheads in processing power and data storage is covered in Section Three.

Such solutions could implement automatic hearing-dose-management with the hearing levels being automatically adjusted to safe levels. However a focus of this disclosure is for the hearing-dose-data to be made conveniently available to users. In the case of child-users it could be made available to a parent or guardian; in the case of employees, it could be made available to their employer. The available information can then become an effective way of preventing NIHL. The schemes described above do not address this area.

### A Summary

This disclosure covers apparatus for communication and the communication of hearing dose information in a suitable format on to suitable devices and systems to facilitate full use of the data being made.

Examples of underlying processes to efficiently generate hearing-dose data in devices such as wireless earpieces are described in Section Three.

Communication of the hearing-dose data can be through any medium available to the wireless hearing device (from here on referred to as a wireless earpiece) to an app resident on a smartphone, and to other systems that can make use of the information.

As distinct from the audio data being transmitted to the wireless earpiece, hearing-dose data may have a low bandwidth. Rather than the -MB/second of audio data, it could be a few bytes per second. A typical scenario would be for this to be communicated to a smartphone via Bluetooth or a similar connection. The smartphone could then communicate this elsewhere, such as through 3G/4G to an internet site.

This disclosure includes the use of a smartphone-resident app connecting with this data and using it to provide suitable hearing-dose-level indication to the user, such as a visual red/amber/green colour scheme (corresponding to warning/alert/safe), a graphical presentation such as dose-level over time, or a numerical indication such as % of day's permitted dose either used so far or available for use.

This disclosure also includes the use of a smartphone-resident app that enables the user to select automatic hearing-dose-management. This can be implemented in the smartphone if it is the source device, or through smartphone-instruction in the wireless earpiece if it has the capability.

This disclosure also includes the monitoring of hearing-dose information through other devices or a website, and if employers or guardians are involved, the enabling or otherwise of automatic hearing-dose-management as described above.

This disclosure also covers the activation of any indicators or display or audible warning devices that are available in the wireless earpieces.

This disclosure also covers the use of wireless communication between the smartphone and an in-line plug-in, plug-out, adapter for use with cable-connected headset, where the adapter has a wireless channel (eg Bluetooth) to link to the phone control and data, and where the adapter conveys the audio signals from smartphone to the headset via suitable monitoring or monitoring and control circuitry within the adapter. This allows the adapter to extract the hearing-dose information from the cabled headset, communicate this to the smartphone as described above, and if necessary undertake the automatic hearing-dose-management for the cable-connected headset.

This disclosure also covers the ability of the parent/employer/user to determine the levels for warning or for automatic hearing-dose-management, in accordance with the different national or regional regulations, or with the wishes of parents/guardians to protect their children's hearing.

This disclosure also covers a wireless headset with an in-built hearing-dose-management scheme being preset by its manufacturer or supplier to a specific region's regulatory levels, so that a "universal" wireless headset will meet local regulations.

This disclosure also covers connection to another system such as a gaming console with its own separate headset, cabled or wireless, whereby this system is able to convey hearing-dose information gathered during a gaming session to a smartphone for integration into the user's hearing-dose profile, or is able to make use of the hearing-dose information described in the above paragraphs to integrate with its own hearing protection schemes where they are available.

This disclosure also covers the parallel communication of associated information such as ambient noise levels, either for information, or for integration with the electronically delivered hearing dose to form a more accurate assessment, or to assist automated level controls that optimise hearing levels to the minimum level that accords with the prevailing ambient noise breaking through to the ears.

This disclosure also covers the use of what has been described hereto as a way of conveying other information from the headset to elsewhere. One example is for the purposes of identifying particular music or sounds. Digital signatures from material played through the wireless headphone/headset can be locally determined and then conveyed to an appropriate database for identification. Alternatively, extracts of the material can be conveyed elsewhere for either direct identification or for generating a digital signature as before. This disclsoure can also be used to transfer track information and similar information from suitable file formats being used with the wireless headphones.

One practical solution is to embed hearing-dose monitoring in a headset cable, or in the electronic source device (such as a smartphone).

**Benefits**

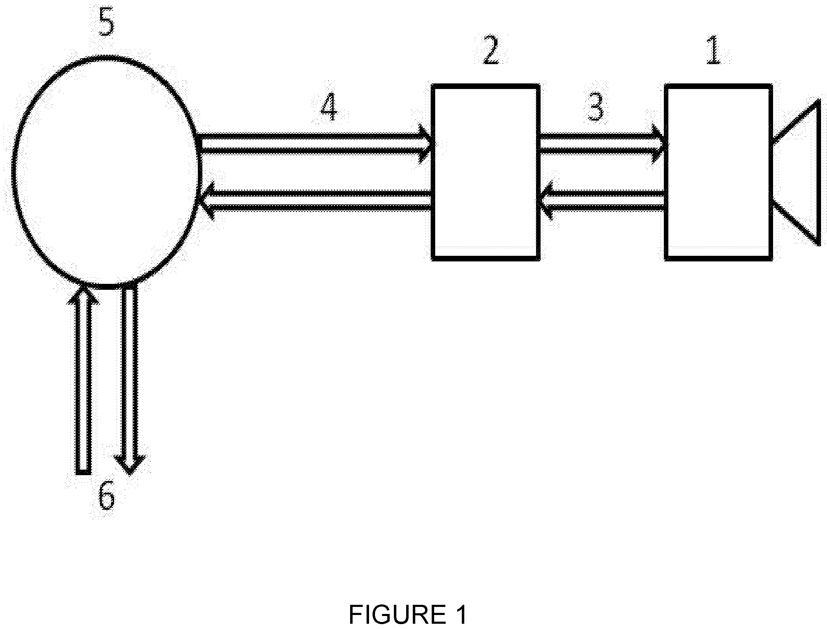

This disclosure aims to gather hearing dose data on a website (5) or on the wireless headset's host (2). Once available, gathered hearing dose data can be used for many purposes including those described here. An example system configuration is shown in **Figure 1.**

The hearing dose data can be used by way of example to guide personal hearing levels, to assist parents care of children or employers care of employees using such devices, and to facilitate a potential system of an automatic hearing dose level control scheme.

This disclosure facilitates an integrated approach to personal hearing dose management with the potential to aggregate information from multiple headsets and systems used through each day.

A responsible parent, guardian or employer can monitor each user's hearing dose so that effective action can be taken if necessary. Trigger levels can be implemented so that automatic warnings are communicated to the parent or employer by SMS or email for example.

A user, concerned parent or employer could enable automatic control of hearing levels to ensure safe levels are never exceeded. Such control could be implemented on the wireless headset's host (2) or directly in the wireless headset (3).

In a similar way, the user, concerned parent or employer could enable automatic audio warnings of pending hearing dose excess; again, this could be implemented on the wireless headset's host (2) or directly in the wireless headset (3).

Health and wellness conscious users, their parents or employers, could gather and monitor statistics of their hearing dose levels over days, weeks etc, allowing them to take appropriate action on listening levels.

Anonymized data could be gathered by deaf or health charities and organisations to provide widespread information about the public's listening habits, and hence efficiently direct their resources to preventative measures. Similarly, such data could be gathered by headset suppliers for improved design or better awareness of the implications of their product's usage.

Reference is made to **Figures 1, 2** and **3,** by way of example.

A wireless hearing device (1) such as a WiFi connected headset interfaces to a portable device (2) such as a smartphone with one or more of the wireless links (3) such as WiFi or Bluetooth Smart. The portable device (2) is connected via any of the wireless links (4) such as 3G, 4G to at least one internet website (5) on which data can be gathered and disseminated. An example configuration is shown in **Figure 1.**

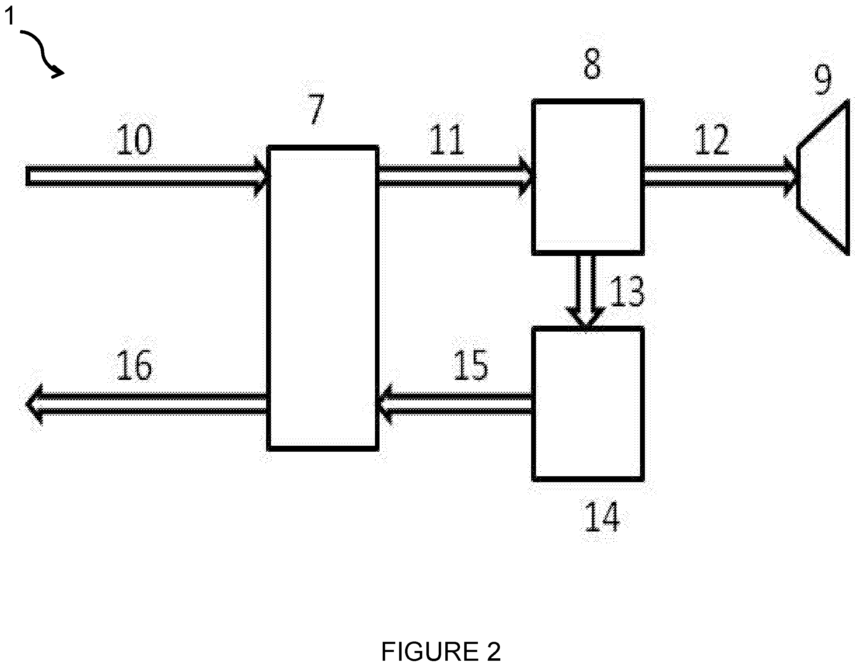

A wireless hearing device, for example shown as (1) in **Figure 1,** is expanded upon here. A main communications and processing unit (7) which features an audio output (8) feeding the earpiece (9) is provided. Sound and other data (10) is communicated via a wireless link, for example wireless links (3) in **Figure 1,** to communications and processing unit (7). Sound data (11) becomes the audio output. An electronic analogue signal (12) is provided to the earpiece (9). A sampling processor (14) gathers hearing dose data from a representation (13) of the output signal. Hearing dose data (15) is fed to communications and processing unit (7) for subsequent communication via the wireless link (16) to a portable device, for example portable device (2) in **Figure 1. Figure 2** shows an example of detail of a wireless hearing device.

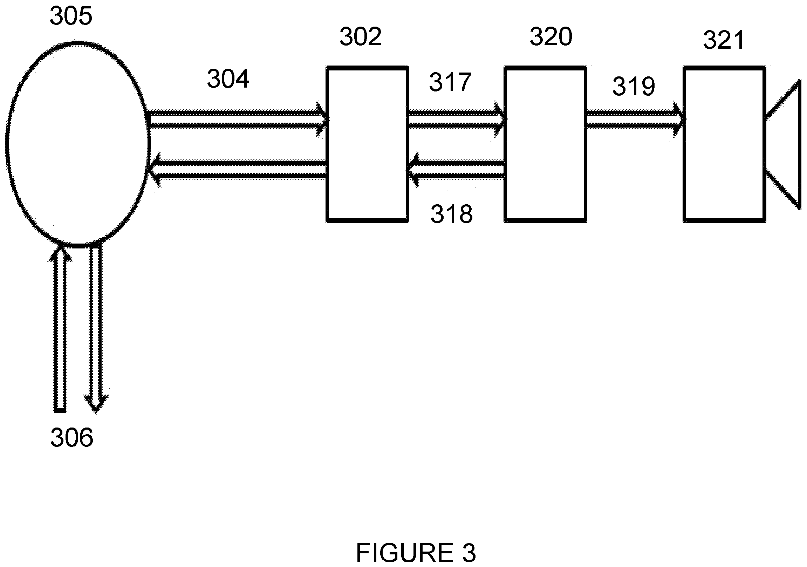

There is provided a plug-in, plug-out unit (320) used between a smartphone (302) and analogue-connected earpiece (321), wherein the analogue output of the smartphone (317) is conveyed via the unit (320) and the unit's possible level-controlling functionality to the analogue signal driving the earpiece (319). A wireless link (318) between smartphone (302) and unit (320) conveys the hearing dose information. An example configuration is shown in **Figure 3.**

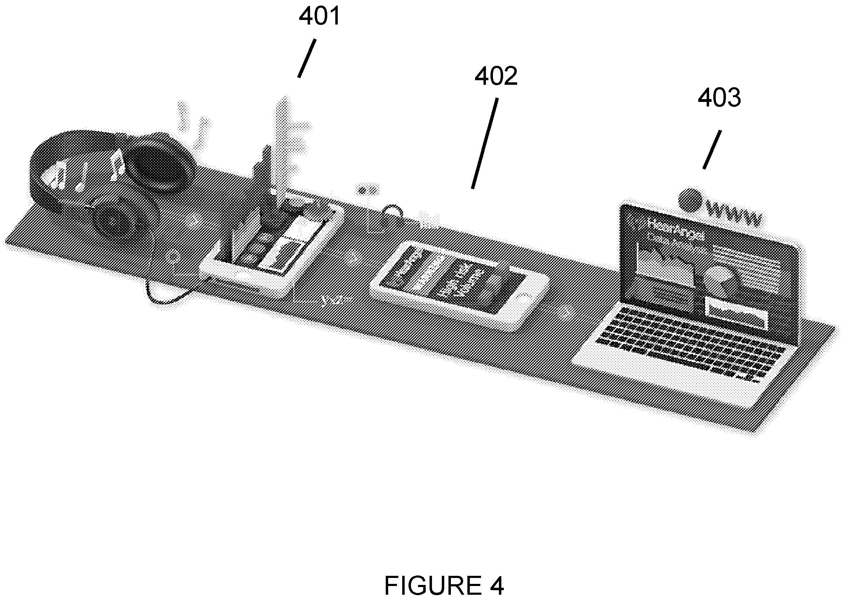

**Figure 4** illustrates an example system, which may be named by way of illustration as HearAngel.

## Detailed Description

**Figure 1** shows an example of overall system features whilst **Figure 2** shows an example of specific aspects pertaining to a wireless earpiece.

Key aspects of this disclosure include accessing hearing dose data extracted within a suitable wireless earpiece based on its output, communicating hearing dose data to a local device such as a smart-phone (2), and communicating that data or derivations of it from any such device to a website (5). From the local device (2) or the website (5), the data can be made available in many ways and for many purposes.

Part of the implementation of this disclosure may reside within the wireless earpiece as embedded code or an app, depending on its internal architecture. Hearing dose data (13) can be extracted from the outgoing data or signals going to the earpiece (9), for example as covered by the following explanatory notes.

The efficient extraction of information from the signals going to the earpiece can be managed in various ways. In the present invention, this is achieved using sub-sampling. As hearing dose is based on energy (power) rather than voltage, some form of voltage to power or squaring operation is necessary.

This data can be averaged over appropriate time periods to form a hearing dose contribution data for each period. A suitable period could be 5 minutes, which would significantly constrain data volume and associated bandwidths elsewhere in the system being described.

Knowledge of the particular earpiece's electrical to audio conversion efficiency may be incorporated in the above data. This will normally be fixed as the earpiece is integral to the wireless headset.

Communication of the extracted data back to the wireless headset's host device is over the same link (16). As this is very low bandwidth data, this is quite practical with slight adaptation of the protocols.

Communication of the headset's host device (eg smart phone) to a website (5) is over any of the available links such as 3G/4G, broadband etc.

This disclosure includes the potential use of signal attributes other than hearing dose from the wireless headset; examples include short but intense peak hearing events that may not show up in averaged hearing-dose data. Such events could be time-stamped, characterised in terms of total energy content, and then added to any data stream of information.

Implementation of this disclosure may be partly in the chipsets associated with wireless headsets and earpieces (1); this facilitates hearing dose and other data extraction and communication to another device (2).

Alternatively this disclosure can be implemented in a plug in, plug out unit (320) which connects physically via cable (317) between the headset or audio output socket of a source device such as a smartphone (302) and any analogue-connected earpiece or headset (321). In this example, data extraction could be through similar apparatus as described above and for example as illustrated in **Figure 2;** communication could be wireless to the local device such as a smartphone via any link (318) such as Bluetooth by way of example. The smartphone (302) may communicate with a website (305) by a wirelesss link (304). An example is shown in **Figure 3.**

Aspects of this disclosure can be implemented in devices such as smartphones to facilitate indication of hearing dose information to the user in a suitable format.

Aspects of this disclosure can be implemented in websites to facilitate data presentation and dissemination appropriate to hearing safety.

Where used for the purposes of identification of material passed through the headset/headphones, this can be implemented in at least two ways. The preferred option is to include digital signature generation within the headset electronics; this will necessitate additional processing functions but minimises the data needing to be transmitted. An alternative is to collect enough samples of the material, convey them to an external processing station. The external processing station can directly use them to interrogate a library of samples, or with advantage can create a digital signature suitable for accessing a database. This could utilise schemes such as Shazam or Soundhound. There is provided functional inclusion in a wireless headset and conveyance of the output via aspects provided in this disclosure.

By way of illustrating one possible example, the following six sections explain how an example could work as an integrated environment, named in the example as HearAngel.

Example of User Registration and Set Up

1) Purchase HearAngel enabled headphones; Hearing Dose Management (HDM) is activated when supplied.
2) User creates a HearAngel account (if first time user) using web, Google, Facebook, email etc.

- Requires user name, valid email address, password and contact number.
- Requires end user licence agreement (EULA) acceptance.
- Requires account activation through link in validation email.

3) Register headphones in user's HearAngel account by either

- Scanning a machine-readable unique identity code on product, its documentation or packaging
- Or by manually entering headphone unique identity on HearAngel website.

One user account can have several headphones registered to a single account.
4) The account holder can initiate an administrative status (examples are parents or employers) with additional password.
5) Administrators can select options for each registered headset:

- HDM ON (data collection + HDM) or HDM OFF (data collection only).
- Ambient noise inclusion in reports.
- Frequency of exposure reports.
- Email destination of exposure reports.
- Share information via social media.

6) Download HDM STAT App to one or more Smartphones. This provides connectivity and HDM status indication.
7) Pair HearAngel with Smartphone using Bluetooth low energy (LE).
8) Pairing methods may include:

- Search for device as normal and enter code.
- Initiate paring in app and then provide physical motion on headphones to identify the device.
- Initiate pairing in app then hold HearAngel to phone, have the phone vibrate in pattern, pickup on microphone and use to identify the device.

- NFC built into the HearAngel.

Example of User Operation - Data Collection Only

1) Using registered headphones in the vicinity of a paired Smartphone with resident HDM STAT App activates HDM in data collection mode. The Smartphone may not be the content source for the headphones, but will be connected through an available link or chain of links such as Bluetooth, Wi-Fi etc.
2) There are no volume level interventions by HDM in data collection mode.
3) If paired with a Smartphone the HDM STAT App's status indicator may show:

- green (no danger)
- amber (approaching danger if you continue to listen at this level)
- red (in danger of excessive hearing dose; reducing volume is recommended).

4) An equivalent status indicator may also be available on the headset, offering the same functionality when the headphones are being used autonomously.
5) Headphones linked to a smartphone or used autonomously (e.g. with a Wi-Fi connection); exposure data is uploaded to the HearAngel website via any link or chain of links.
6) HearAngel website automatically produces and sends graphical reports to the email address specified during set up process.

Example of User Operation - Data Collection and HDM

1) Using registered headphones in the vicinity of a smartphone with resident HDM STAT App activates full HDM mode if HDM ON has been selected in administration settings. As in the data collection only mode, the headphone will be connected through an available link or chain of links such as Bluetooth, WIFI etc. According to the available links, this could be to a Smartphone and the HearAngel® website.
2) The user is automatically protected. Time, volume and density are monitored and intervention will take place when combination approaches the recommended hearing health limits.
3) If linked with a Smartphone, the HDM STAT App's status indicator may show:

- green (no danger)
- amber (approaching danger if you continue to listen at this level)
- red (in danger of excessive hearing dose; reducing volume is recommended).

An equivalent status indicator may also be available on the headset, offering the same functionality when the headphones are being used autonomously.
4) Headphones linked to a smartphone or used autonomously (e.g. with a Wi-Fi connection); exposure data is uploaded to the HearAngel website via any link or chain of links.
5) HearAngel website automatically produces and sends graphical reports to the email address specified during set up process.

Example of Administrator Operation (post set up)

1) Active directory administration for business use.
2) Receives email reports, to schedule they have specified, for all of headphones under their control. Reports could also go into an account and a status report sent.
3) In the case of occupational purchase data stored for defence against future noise induced hearing loss cases.

Example of Headphone Manufacturers Operation

1) EULA permits the headphone manufacturer to contact the user via HearAngel or perhaps directly.

2) In the event that a headphone company is subject to noise induced hearing loss claims, it may request the exposure data from HearAngel to assist with its defence. In addition to the exposure data HearAngel will capture information around the activation and deactivation of the HDM function.

Example of HearAngel Operation

1) EULA permits the headphone manufacturer to contact the user via HearAngel or perhaps directly.

2) May sell access to the HearAngel users to organisations that offer streaming services.

3) May sell user data to third parties.

By way of illustrating one possible example of this disclosure, the following section indicates some of the technical specifications that could be used to describe what is named in the example as HearAngel.

Example Technical specification for HearAngel

HearAngel continuously measures how long you listen, how loud you listen and what you listen to, automatically building a profile of your hearing exposure (401). The data is presented, eg. on a screen of a smartphone, eg. in the form of status alerts, eg. coloured status alerts (402). Via a web app, the HearAngel system can present (eg. on a computer screen) detailed analysis of your exposure and potential risks (403). HearAngel does not affect the quality of sound you hear, is unobtrusive, simple to use and a most effective way to manage your hearing health. **Figure 4** illustrates one possible example of the system.

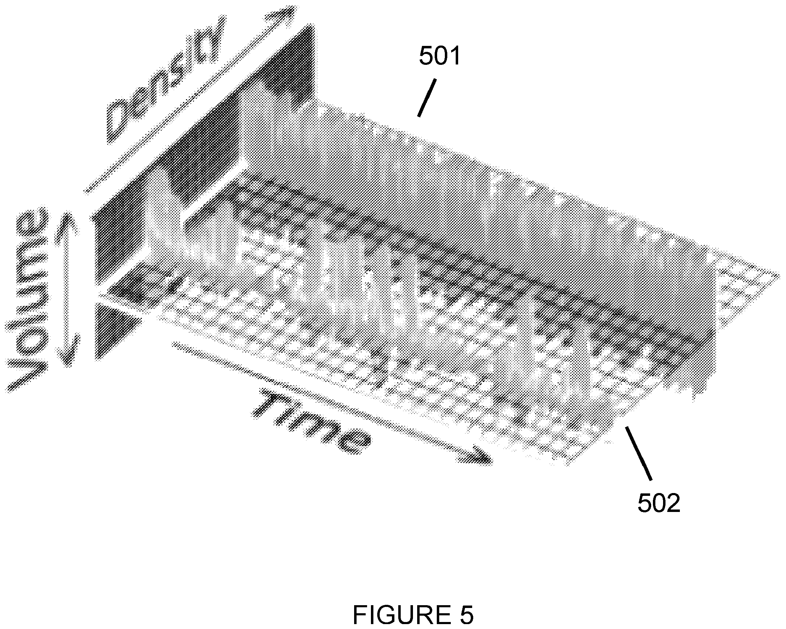

HearAngel takes account of differences in audio traces in its advice and protection calculations. For example, the two audio traces in **Figure 5** are very different. Trace **501** represents electronic and rock music - high density and high volume. It is easy to understand why this may be damaging to hearing. Trace **502** is typical of spoken words eg. podcasts and audiobooks.

Protecting your hearing whilst using headphones. HearAngel learns how much and how long you have been listening and provides information to help you make informed decisions about your hearing, or that of your children or employees. You can set HearAngel to automatically manage your listening experience or provide you with the information to do it yourself.

In an example, it would be impossible to monitor every element of your own exposure and effectively protect your hearing without the help of HearAngel.

HearAngel may be implemented using a headphone accessory. HearAngel may be implemented as built-in to wireless headphones.

HearAngel may work in combination with a smartphone for instant status and web app to provide you with detailed analysis. Data can be shared with your friends using social networks and can be combined with other health monitoring data using standard protocols to provide a comprehensive picture of your health.

Example of Hearing Dose Monitoring

- Has no adverse effect on sound quality.
- Delivered as a self contained Plug In Plug Out (PIPO) device or as licenced embedded software, in intelligent headphones, linked to app and web app.
- Protected algorithms monitor the user's listening period (time) how loud they listen (volume) and the type of sound they listen to (density) and send the data to a Smartphone, tablet, PC or other web connected device.
- Data is compared with hearing health recommendations.
- Alerts are transmitted to app in Smartphone which has red/amber/green format to inform user of current status.
- Data transmitted to web app for compilation into daily/weekly/monthly reports for the user.
- Reports emailed to user and or a supervisor (parent or employer).
- Reports can be shared via social media.
- Data can be delivered into other health monitoring apps via standard protocols.

Example of Connectivity

- PIPO communication to Smartphone and web app by low power, secure Bluetooth 4.
- Software uses host headphone communications including Bluetooth and Wi-Fi.
- Compatible with iPhone 4S onwards.
- Compatible with Android devices running Bluetooth LE.

Example of Headphone and earpiece compatibility

- PIPO suitable for use with MP3 or other personal music players and matched headphones.
- Calibrated for headphone impedance and sensitivity using coded tone and or wireless.

Example of User interface

- Red/amber/green status indicator on Smartphone.
- Web app for product registration, settings, detailed information and reporting.
- In the case of over dosing, a forecast deafness date.

Example of User Additional Features

- Uses the data from the Hearing Dose Monitoring to automatically intervene when the user is in danger of exceeding the hearing health recommendations.
- Software for intelligent headphones and earpieces includes peak sound level protection
- Activated on supply, can be disarmed by the users once registered via the web app.
- Activation is password protected, so a supervisor (parent or employer) can prevent user deactivation.
- Employer can lock protection on and build employees exposure data as evidence for their defence against future legal action.

Example of Extensions to the Disclosure

- Integration of ambient noise exposure contribution from in built microphone in the PIPO or intelligent headphones and earpieces.
- Headphone and earpiece sound quality optimisation in the form of dedicated equaliser for each model of earphone.
- Genre listening period analysis.
- Location of exposure from both headphones and ambient sound.

**Concepts**

1) The communication of hearing-dose related data from a wireless earpiece, headset or headphone to a device such as a smartphone for display.

2) As concept 1, where the information is also communicated from the smartphone (or similar device) to a website for further data analysis, monitoring etc.

3) As concept 2 where the further data analysis, monitoring etc is managed on the smartphone.

4) As concept 1 where the communication is indirectly between the wireless earpiece (etc) and smartphone, where absence of a direct link between these can be substituted through connections such as Bluetooth to another source device (other than the smartphone) and then linked to the smartphone.

5) As concepts 1-4 where the data could be used to automatically control the source device output level and thus instigate automatic hearing dose management, either through functionality embedded in the wireless earpiece or through level-control functions within the source device.

6) As concept 2, where the data could be made available anonymously for public health organisations, headset and device manufacturers and trade associations etc.

7) As concepts 1-6 where information on hearing dose or other critical noise parameters can be displaced or indicated on the wireless earpiece.

8) As concepts 1-7 where hearing dose information from other systems in use by the user throughout the day can be integrated before being communicated to other devices or websites.

9) An alternative that uses a physically connected device between the audio source device and analogue-connected earpiece or headset, where the device is able to extract hearing-dose and related information from signals and convey them wirelessly to another device such as a smartphone or via cable so as to effect any of the above concepts.

10) As any of concepts 1-9 where the wireless earpiece supplier can preset any in-built sensitivity or hearing protection schemes to suit particular regional regulatory variation, facilitating the manufacture of a universal device.

11) As with concept 10 where a guardian or employer can determine particular thresholds or operating levels of hearing protection schemes such as hearing dose management.

12) The use of any of concepts 1-11 for the purposes of sound/speech or music identification, where a digital signature of the material is periodically generated and conveyed using the substance of concepts 1-11 to an external database for identification.

13) As with concept 12 except that samples of the material are conveyed from the wireless headset using concepts 1-12 to an external digital signature generator, and then to a database for identification.

14) As with concept 12 where a database is held locally, such as in the wireless headset, so that direct identification of some sounds can be achieved.

15) As with concept 14 where it is used to restrict access or loudness for some material, such as parental restriction of the playing of video games.

16) As with any of concepts 1-15 where supplementary data such as track information on the music/speech etc data being played is conveyed from the wireless headset, being extracted from file formats where available.


**Section Two** - **Hearing Dose Management**

This disclosure relates to an enabling technology for effective accurate Hearing Dose Management (HDM) in digital and analogue sound sources which may be delivered by a number of methods including as an App, as software or embedded in the source devices hardware.


**Introduction**

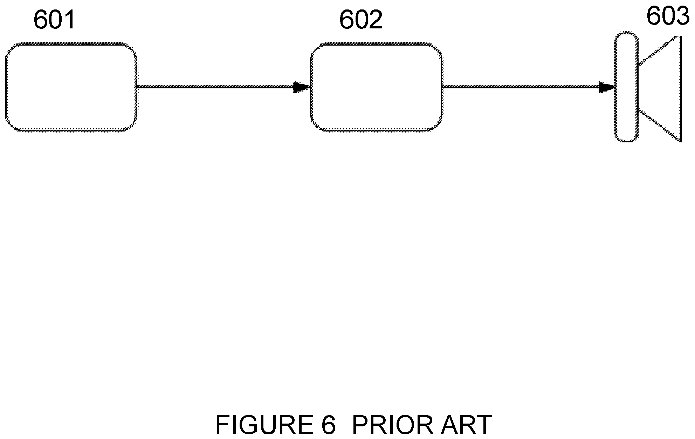

Three components of a basic sound delivery system are illustrated in **Figure 6,** which expresses prior art. The source device (601), controlling device (602) and earpiece (603) are the principal elements involved. In this document, "controlling device" or "level-controlling device" represents the ability to control the electrical energy passing to the earpiece for the purpose of generating acoustic signals. This could be embedded in the earpiece, in the source device, or in a separate unit such as a cable-mounted pod. Typically there is separation between earpiece and the controlling device.

The nature of programme content also has significance. For a given maximum such as dictated by any electronic source device, occasional speech of high quality or light piano music will deliver much lower average energy than highly compressed and continuous music as is readily available. A range of effective average energy compared with peak, often expressed as crest factor, can result in another 20dB of variability in delivered noise exposure.

Where there is the possibility of switching between source content, such as a sound-card being used for several different applications and each with its own level control, the step-change in sound level on moving between applications can be very significant.

All of these factors combine to determine the hearing levels delivered in any particular situation from a particular electronic sound source device, programme content and earpiece combination. Many of these are affected by the differing frequency characteristics of both earpieces and programme material.

Any attempt to match earpiece, programme and source device characteristics is faced with the significant challenge of very poor quality of published data about them. Without this data being brought together, any serious attempt to provide noise exposure control in a source-device is likely to be ineffective, resulting in potential harm to earpiece users. This disclosure seeks to facilitate coordination of data that ensures a greatly reduced risk of hearing damage.

## SUMMARY

A main purpose of this disclosure is to deliver data about an earpiece to the level-controlling device, typically embedded in the source device. Using this data, the controlling device can better use its available monitoring and control facilities to deliver appropriate hearing levels. This offers a significant reduction in noise-dose uncertainty, thus better protecting the user's hearing.

Additional advantages result from part of the implementation of this disclosure likely to be distributed as an App for use on intelligent source devices such as smart phones. Earpiece or source device manufacturers could defend against litigation from consumers who may have suffered NIHL. Download records will establish if the consumer has taken the opportunity to download the HDM App. If they have not, the manufacturer may have a reasonable defence against the claim on the basis of the user's contributory negligence. Download records may also provide a valuable marketing insight into the customers who are buying the manufacturers products and a method of future contact.

A/ This disclosure can be implemented in a wide range of devices:

Implementation details vary according to the particular way of controlling or limiting the signal level in the earpiece, the sophistication of the controlling device, and the physical arrangements of the various entities involved. Although some implementations are better able than others to manage the noise-dose received by the ears to within safe levels, all are improved by this disclsoure. To illustrate the disclosure and its benefits, three examples in decreasing levels of sophistication and effectiveness are described.

1- An idealized control device, able to monitor and integrate noise-exposure over long periods (e.g. 24 hours) and warn the user or actively control the level delivered to the earpieces accordingly.

2- An intermediate control device, with some ability to estimate the signal level being delivered to the earpieces, and warn the user or actively control it.

3- A basic control device only able to control a signal level being delivered to the earpieces.

1) An Idealized Control Device

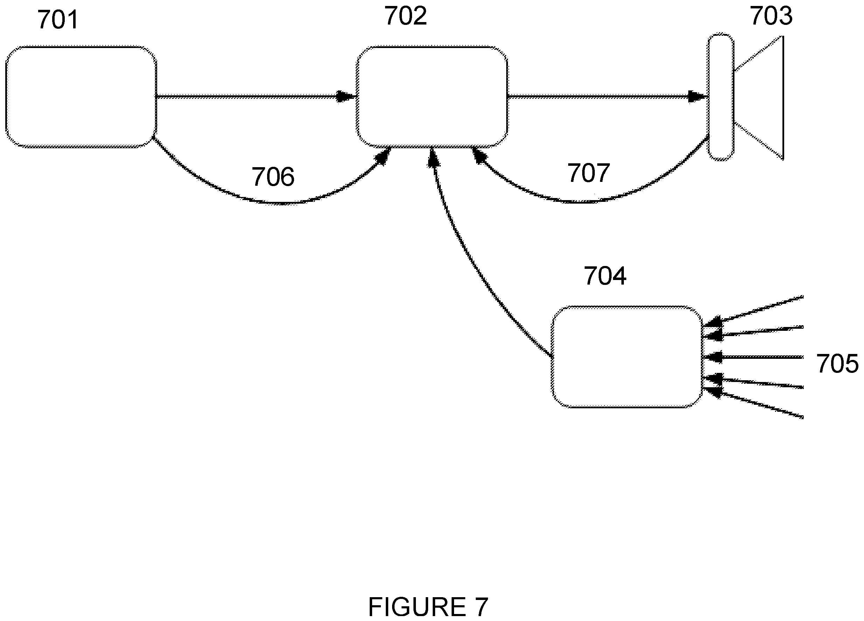

A comprehensive solution that delivers accurate management of the noise-dose for an earpiece user at the highest safe hearing levels requires sophisticated processing, either in hardware or software. A source device (701), level control device (702) and earpiece (703) have previously been described. An advance is mainly the device/application/method (704) whereby data about the earpiece is accessed and delivered to the controlling device. An aspect of this disclosure is the method, system or apparatus (705) whereby the data can be accessed such as QR codes or RFID and many others. Data about the source device and its programme content (706) and data about the signals being sent to the earpiece or acoustic levels from it are provided (707). **Figure 7** illustrates principal features by way of example. Time is necessary for any dose-integration. This implementation could follow the stages outlined here:

a) In an implementation not covered by the present invention, the acoustic energies in different frequency bands to match the A-weighted measurement would be determined and ideally re-weighted in accordance with the non-obstructed acoustic field rather than the resonant levels inside the ear. These bands can be consolidated into a single noise-dose contribution. This matches the approach of workplace regulations.

b) If the earpiece impedance and sensitivity data are known, acoustic energies can be estimated through assessment of electrical energy over the frequency bands. Additional allowance or measurement would have to be made for noise dose contributions from ambient. This allows much more control of hearing dose to be effected and is the key aspect of the present disclosure. Note: Impedance is especially important if there is significant output impedance from the source device.

c) Determined noise-dose contributions need to be integrated over the appropriate period; workplace regulations typically define a day as appropriate for most purposes. Based on the integrated noise-dose contribution, either indication to the user and/or direct control of the hearing level can be implemented.

d) The users hearing dose may be recorded and captured either locally or remotely. This data may be used to create dose information, alerts, routine or exception reports for the user, third party (e.g. an employer, insurance company or parent), or a monitoring device or facility. These hearing dose histories can be downloaded manually or automatically to a nominated third party or to a database.

17

QR code (abbreviated from Quick Response Code) is a type of matrix barcode (or two-dimensional barcode) first designed for the automotive industry in Japan. A barcode is a machine-readable optical label that contains information about the item to which it is attached, or with which it is associated.

2) Monitoring and Control (Intermediate) Device

A less sophisticated control approach can benefit from this disclosure. A variety of techniques such as sampling the output signal, determining its average volume or envelope, etc, can lead to an approximate assessment of the signal output being generated by the source device. This would account for much of the large variation in potential noise-exposure. With the addition of information about earpiece characteristics, the delivery of which is described in this disclosure, a much improved assessment of hearing dose can be achieved. Sampling techniques are one way of radically reducing the processing requirements, or additional hardware, that are needed for the "idealized control device".

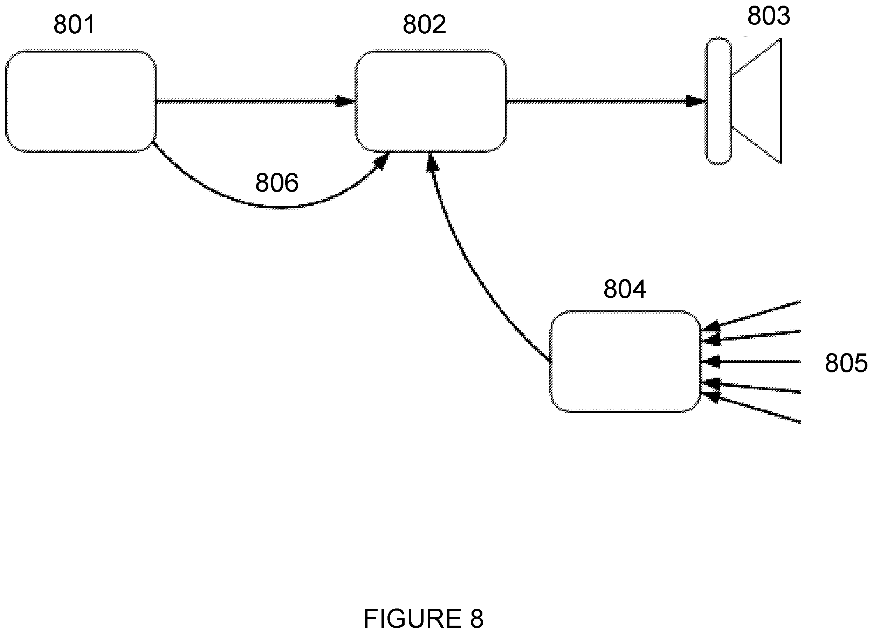

**Figure 8** illustrates an example of the key features of this implementation example which differs from **Figure 7** in the level of sophistication of data about source device and programme content (806), absence of direct feedback from the earpiece (i.e. nothing in **Figure 8** corresponding to (707) in **Figure 7**), and relatively simple ability to assess dose in order to warn or assert level control.

3) Basic Control Device

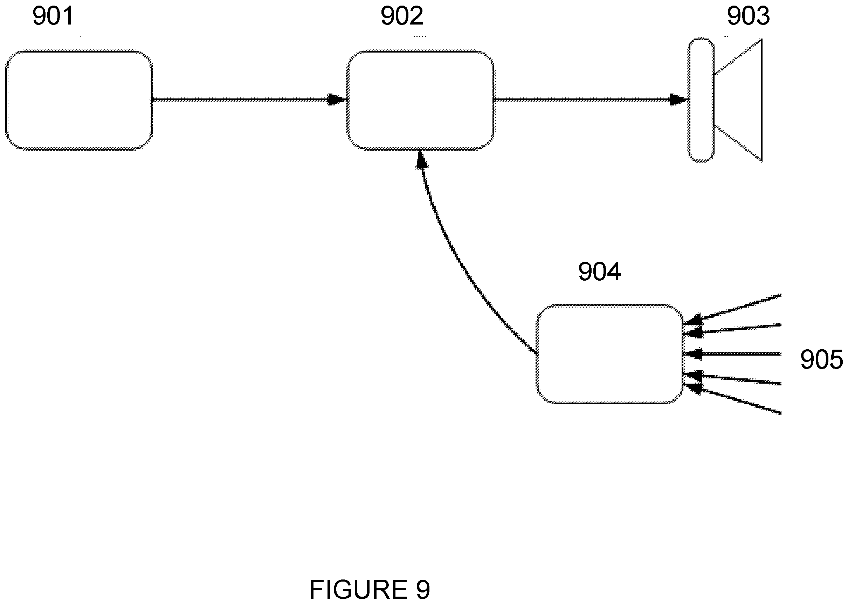

Where there is no capability in the source device to determine any approximate measure of output signal level, a further assumption has to be made based on the maximum output capability (usually based on maximum output voltage), the current volume setting (usually under software control), and an estimate based on typical programme material for the likely rms voltage. With the availability of earpiece characteristics (a subject of this disclosure), it is then possible to make an improved estimate of the delivered hearing dose and hence implement control of the level going to the earpieces. Note: This is much less accurate to the previous examples, but better than what would otherwise be possible. **Figure 9** illustrates the key features of this implementation example which differs from **Figure 8** in which there is an absence of any data about source device and programme content (i.e in **Figure 9** there is nothing corresponding to (806) in **Figure 8**). The data available may be limited to source device output drive capability (such as peak voltage and current), generalised programme content (such as typical MP3 levels rather than any particular MP3 material), and the level control characteristic (such as what to do to reduce signal by 3dB).

A Source device is provided from where the basic signal energy comes from; examples could be an MP3 player, SmartPhone etc. (701, 801, 901). A level controlling device is provided, able to alter the level of electrical energy delivered to the earpiece (702, 802, 902). This could be embedded in source device (701, 801, 901) either before or after its output power amplifier; other examples of its location are embedded in an earpiece (703, 803, 903), or as a separate unit such as cable-mounted pod (not illustrated). There may be more than one level controlling device, such as a manually operated volume control together with a software or voltage controlled device. An earpiece is provided (703, 803, 903); this is any transducer that converts electrical energy to acoustic energy. Apparatus (704, 804, 904) is provided by which relevant electro-acoustic data for the earpiece is transferred to the controlling device. Data (in particular electro-acoustic data) (705, 805, 905) is provided related to the earpiece; this can arrive from many sources as indicated in the description of this disclosure.

Data (706, 806) may be provided related to the source signal; this can be of various levels of sophistication, but may not be available at all in some applications. Data (707) may be provided related to the electrical signal sent to the earpiece, or to the acoustic signal generated by the earpiece; in some applications this may not be available.

B/ This disclosure includes a range of possibilities for delivering the data:

1) The earpiece, its packaging or both can incorporate or have a machine-readable identifier that enables the controlling device to access earpiece data via the internet, mobile communication system or some future communication system. The identifier can be a barcode, QR code, RFID (radio-frequency identification device), or a concealed-code such as those offered by Signum Technologies (http://www.signumtech.com) or suitable alternatives; it could be based on any other identification technology which can be read or interrogated by the controlling device. Appropriate data on the earpiece could be downloaded, either automatically or with user authentication to the controlling device. Typical data would be sensitivity and impedance. This would enable more appropriate control of the delivered energy to the earpiece, no matter how sophisticated or otherwise the controlling device was.

2) The earpiece, its packaging or both could alternatively incorporate the earpiece data into any of the above mentioned technologies or others. This would avoid the need to access internet or other external facility; the amount of such data may be constrained.

3) The machine-readable code on or in the earpiece assembly, its cable, its packaging or both, could be a code that relates to a pre-loaded or embedded table of earpiece data. One example would be if the table was included in an "APP" downloaded to the controlling device.

4) Other encoding schemes could be utilised, such as resistance or impedance, digital encoding such as 1-wire devices.

5) Any of the above could be based on industry-wide standards, so that different manufacturer's devices could be used with each other in safety.

6) Alternative external apparatus to internet, such as intranet, WiFi, GSM and any other networking or data transference schemes, may be used.

7) Use of group or corporate facilities to install, initiate or change earpiece data for several phones or devices, an example being TETRA network facilities or where an organisation may wish to manage exposure from headphones used for Skype or VOIP.

8) Users could be part of the data transference method; an example would be copying data from a webpage automatically located by the machine-readable code. Thus an automated, semi-automated or even fully manual scheme to place data in the controlling device can be used.

C/ This disclosure can be used with a wide variety of controlling devices:

1) SmartPhones of the various kinds, including those based on Android, iOS, Microsoft or Blackberry for example.
2) Tablets, readers and the like
3) Any desktop or portable computing device
4) Any other hand-held or portable device that delivers energy to earpieces etc
5) Any portable radio such as TETRA, digital PMR for example
6) Any Bluetooth or similar device providing wireless communication to the earpiece
7) Any other device such as games consoles that could control the level of sound from earpieces.
8) Any other devices (eg. that may be introduced in the future) such as Google Glasses, dongles and implants for example.
9) Any form of centralised processing facility that can deliver or participate in HDM.

D/ The earpiece data can be used in several ways to improve HDM for the user:

1) A sophisticated HDM as described above, using as much earpiece data as available to assess the noise-dose as accurately as possible. This is described more fully in section A/1).

2) Simple volume level adjustment, using assumptions about the relationship between volume level, peak source signal, typical programme content, and recent length of listening period. With the benefit of earpiece data, a more appropriate operating level for the earpieces can be set. This is described more fully in section A/3).

3) Sampling the delivered signals to more accurately assess their energy content; using the assessed energy level together with the earpiece data, better estimations of noise dose can be made compared with the above simple technique. This is described more fully in section A/2).

4) Direct control of the listening level can be implemented, based on past and present noise-dose estimation and an assessment of likely dose available for the remainder of the day or similar period.

5) Improved indication to the user of the noise-dose delivery, enabling the user to make more informed adjustments of the listening level to avoid hearing damage.

6) Capture of data for the user or a third party of information relating to the users hearing exposure whether that information is available directly from the device or transmitted elsewhere.

7) Potential of gathering a history of dose estimates for subsequent manual or automatic up-load to a PC, internet or some form of data logging device. This would enable longer term monitoring and management of hearing dose to be effected.

8) Potential of communicating the occurrence of significant noise-dose or other noise events to a 3rd party (e.g. an employer, insurance company or parent), or a monitoring device or facility.

9) Adaptation of this to bone-conduction devices is included in the scope of this disclosure.

10) Inclusion of measurements of the ambient level, as with integral microphones, is included in the scope of this disclosure.

11) Integration with active-noise-suppression technologies is included in the scope of this disclosure.

E/ The process to make use of the dose management data can be implemented or conveyed in several different ways:

1) As an application ("APP") loaded onto a SmartPhone or similar device; this APP can then utilise any of the device's hardware or firmware to manage or process an appropriate method of HDM, using the earpiece data.

2) Delivery of the functionality through other media, such as DVDs, USB sticks etc, to devices such as games consoles etc.

3) As part of the device's operating system or a lower-level application; this ensures the HDM process is embedded in such a way to avoid being displaced by an HDM-defeating APP, a common experience where SmartPhone providers have attempted to provide basic level limits.

4) Implemented at least in part in hardware, for example as part of one of the device's application-specific integrated circuit (ASIC). It could also be part implemented with analogue functionality to significantly reduce some of the required processing power to implement a sophisticated HDM solution.

## DETAILED DESCRIPTION

The full operation covering these stages is described here for a particular implementation in a smart-phone; and example of basic data flows is illustrated in **Figure 7.**

The intelligent source device (e.g. smart-phone) typically has a default output level, based on user-set volume, the electronic source content, and the basic architecture of its output stages that deliver energy to the earpiece. This, together with the earpiece characteristics will result in a particular rate of delivering contributions to the user's daily hearing dose level.

Prompt for registration. With an implementation of this disclosure installed as (for example) as an App in the smart-phone, the user will be prompted to register the particular earpiece being used during the normal protocols associated with first use of the smart-phone. Optionally, the user could be prompted each time an earpiece is connected to the smart-phone. Additionally, the user could access the registration facility through the normal setting facilities. If there were additional apparatus for communication with the earpiece itself, the prompt for registration could be automated through detection of changed earpiece.

Registration option menu. Following the registration prompt, the user is presented with a series of options for registration. The many ways such data can be made available were described in section B.

An example of the registration option menu is:

Direct detection from hearing device?
Manual entry?
Scan?

If direct detection is selected, the App proceeds to interrogate the earpiece and retrieve available data. As described elsewhere, the data could be the characteristics of the earpiece, or could be a code to facilitate access to such data, either from an internal or external (e.g. via internet) database. If via internet, this could call on the appropriate resources available to the smart-phone.

Scan options could be:

Scan QR?

Scan barcode?
Scan other (RFID etc)?

Any of these can call on the particular facility or App resident in the smart-phone to scan in the available data. As described in "direct detection", this could be the necessary data, or could facilitate access to it.

Manual entry options could be:

Earpiece type?
Earpiece code?
Earpiece data?

Earpiece type would facilitate selection and identification of the particular earpiece being connected. Selection could be based on internal database of types. Alternatively it could be internet-based, using an accessible database with suitable selection options such as brand, manufacturer or model number. Access to such an external database could be facilitated through the smart-phone's existing resources.

Earpiece code would enable a specific code for the earpiece to be entered to enable access to either an internal or external (such as via internet) database. This would greatly ease the challenges of identifying particular models. The earpiece code would be incorporated in the product case, packaging or literature, and thereby convey the vital data on its characteristics.

Earpiece data would allow direct entry of sensitivity and impedance data for the earpiece. This presumes the user has access to such data and knows how to make use of it. Unfortunately, manufacturer's data on sensitivity is expressed in different terms such as dBA SPL /mW or dBA SPL /V. Users need to be carefully guided and appropriate checks included in the data entry to throw out erroneous or highlight unlikely entries.

Regulating the output level. Through the above options, appropriate data on the earpiece is made available to optimise the user's hearing dose. How this may be managed in a sophisticated intelligent source device is described here.

Simplistically, for a given earpiece sensitivity S (dBA SPL/volt) and a given output level L (volts rms) being delivered to the earpiece, the hearing level is S x L (dBA SPL).

For more precision, sensitivity needs to be seen as a function of frequency. In part this is due to the earpiece itself, but it also relates to the resonant conditions within the ear canal. Regulatory hearing dose limits and expressions of safe levels are in terms of an equivalent level in a diffuse sound field near the user rather than the resonant conditions within the ear canal. These levels have a frequency dependent relationship. Hence the ideal sensitivity data for an earpiece is based on the diffuse sound field near the user.

Knowledge of the output level (L) may have to be assumed, based on typical programme content and the characteristics of the output amplifier. More accuracy and so better protection can be effected through using at least an estimate of the actual programme content being delivered to the earpiece. Ignoring frequency dependence, this could be through determining the root-mean-square (rms) voltage. This can involve a significant processing overhead, and so alternatives based on sub-sampling techniques will be sufficiently accurate to make a useful improvement on simple estimation described above. Sub-sampling could involve the App extracting signal data samples at a low rate to suit processing overheads; over time these will broadly represent the level of signal being sent to the earpiece.

If the intelligent source device has access to the spectral content of the programme content, or if it has the capacity to determine this, then a much improved estimate of output level with its frequency dependency L(f) can be used in the output level control determination.

Integration of this over time yields the accumulated hearing dose. This can be compared with the safe hearing dose limits (HDL) to warn the user, and could also be used to intervene and actively reduce the output level. With some anticipation, this can ensure hearing dose is always within safe limits. Again, the frequency dependence of safe levels can be included HDL(f) for improved accuracy and reduced hearing damage.

The hearing dose limit (safe level) is typically defined as 85dBA SPL when averaged over 8 hours in a day, or the equivalent. Thus 88dBA SPL can be the equivalent day's hearing dose if averaged over 4 hours, and 82dB SPL if averaged over 16 hours. This allows the ongoing hearing dose contribution through the earpieces to be compared with safe limits in short, medium and long time periods as necessary. The prediction and management of such a scheme is beyond the scope of this disclosure, but will only be possible if accurate data of the earpiece characteristic is made available to such an algorithm.

For the simple system that ignores frequency dependence, the time-integral of (S x L) is to be compared with HDL as described above. An improved system will perform the same comparison, but based on the various contributions at each frequency. This can be expressed as comparing the time-integral of S(f) x L(f) with the hearing dose safe level HDL(f).

However the determination is made, a more appropriate output level can be indicated to the user, or can be implemented through direct control of the output level.

Use of impedance data. Although most source devices have output impedances significantly lower than most earpieces, some do not. Finite (i.e. non-zero) output impedance will affect the level being delivered to the user if earpieces of different impedance are used. If output level into high impedance (open-circuit) is Loc and the output impedance is effectively Zout and earpiece Zear, then the signal level delivered to the earpiece is Loc x Zear / (Zear + Zout).

Thus knowledge of the earpiece impedance can form a significant aspect of determining estimate of delivered hearing dose in systems with significant output impedance. As with all of the above calculations and descriptions, impedance of earpieces is typically frequency dependent. Data of this frequency dependence could also be included.

App implementation. Apps on smart-phone and similar devices are easily displaceable by other Apps or the system operating system. It is thus advantageous to include the described functions in as low a level in the device as possible, even as part of the basic functionality of the operating system itself.

Some of the sophisticated processing described can be implemented in "silicon" of the various processing chips involved. The advantage here is to allow improved estimates of hearing dose, without onerous overheads in the operating system.

One option to save significant processing is to implement analogue processing, such as monitoring the output signals delivered to the earpiece. Simple filtering, rectification and averaging could greatly reduce digital processing overheads and consequent power consumption, whilst delivering greatly improved accuracy in hearing dose estimation.

**Concepts**

1) The use of machine-readable codes, identities and features to convey information about an earpiece, headset, in-ear-monitor or other hearing device to a device that has the potential to control the level of signal being delivered to the earpiece.

2) As concept 1 where the information is included in the machine-readable scheme, such as earpiece sensitivity data being embedded in a QR code.

3) As concept 1 where the information is indirectly accessible through the machine-readable scheme, such a URL being embedded in a QR code and used to access data via internet.

4) As concept 1 where the information is accessible through the machine-readable scheme such as with an index code being embedded in a QR code and used to access a pre-loaded table of data accessed by the controlling device.

5) As any of the above concepts whereby the controlling device is part of the earpiece device.

6) As any of the above concepts whereby the controlling device implements control through a device or function distinct to both the earpiece and device that reads the code, such as remote control of earpiece levels through a central computing system lined to individual users.

7) Record the users hearing dose either locally or remotely for later examination. Data may be used to create dose information, alerts, routine or exception reports for the user, third party or a monitoring device or facility.

**Section Three** - **Efficient Hearing Dose Management**

This section relates to hearing dose management. A novel approach is provided to hearing dose management by controlling signals feeding earpieces, where power consumption and processing resources are constrained and economical control elements are used. This scheme monitors earpiece usage over extended periods of time, uses the framework of noise-related regulation to make the best use of permitted sound levels, and matches the control requirement with the available control element.

**Introduction**

Noise-induced hearing loss (NIHL) is caused through either intense short-term noise events or through excessive levels over a period of time, often termed excessive hearing noise dose. This disclosure relates to using earpieces of any kind and relates to improved techniques for managing hearing dose to ensure that harmful levels are never reached.

To effectively manage hearing dose in the many practical working and lifestyle scenarios and associated ambient noise levels, two functions have to be performed: relatively long-term monitoring of hearing-dose contributions, and either providing a warning indication to the user or providing active preventative measures such as reducing the hearing level.

Regulations and hearing health guidance typically relates to a day's listening period, and specifies the limits in terms of an effective hearing dose level over the day. Short-term levels can be high as long as the day's hearing dose is within limits. To make the most use of safe (and legal) hearing levels, hearing dose management technology needs to take a long-term view, thereby allowing short-term high-listening levels to be safely accommodated.

For technologies that are to be embedded in the earpiece cable, or the earpiece itself, monitoring the hearing dose is most efficiently managed through monitoring the electrical signals feeding the earpiece. This has to be in conjunction with knowledge of the relationship between these signals and the sound levels entering the user's ears, such as in the form of earpiece sensitivity in terms of dBA SPL per volt.

Any such technology may therefore meet the challenges of low-cost, small-size, low-power and high-quality, in addition to the needs related to hearing dose management.

Where active hearing dose management is implemented (rather than merely indicating warnings), a method of reducing the signals feeding earpieces is necessary. To meet the low-power requirement, this necessitates some form of passive attenuation such as through the use of JFET or MOSFET devices, as opposed to any form of variable-gain amplification. Such devices are effectively voltage-controlled resistors, and can be configured to provide effective attenuation. However, their manufacture results in a wide spread of characteristics, with a critical parameter, gate threshold voltage, often having a 2-1 range. This makes some form of production adjustment necessary.

Where precision control of hearing dose levels is to be implemented, thereby allowing the full realm of safe hearing dose levels to be available, more sophistication in managing the attenuation device's variability is desirable. With the vast range of possible hearing levels, and uncertainty in how any particular degree of attenuation is to be achieved, this makes for an extremely difficult control loop to stabilize and yet maintain precision management.

The present disclosure addresses the challenge of delivering a technology hearing dose management for users of any kind of earpiece, whilst meeting the constraints of low-cost, small-size, adequate-safe-hearing levels, and low power consumption. This offers a solution that makes best use of available low-cost technology and can be implemented in hardware, firmware or software.

**Problems**

A whole day's listening experience expressed in terms of raw signal data could be 10Gbytes; digital processing of the signals represents a significant task, especially when including the regulatory prescribed A-weighting filtering. This is practical in DSP (digital signal processing) devices but necessitates higher cost, larger size and more power than would be most appropriate for the widest possible usage.

By suitable pre-processing, including filtering, it is possible to greatly reduce the data involved whilst still properly monitoring and managing hearing dose to meet regulatory requirements. For example, rather than sampling at 96KHz or so to capture the raw signal, sampling at a few Hz with 2 bytes per sample could capture sufficient information but with perhaps only 1Mbyte over the day and using much lower processing power.

Even this is too much for the very lowest-cost and lowest power devices such as micro-power microcontrollers. For cost, size and power, if the data storage and processing could be reduced further, these could be the preferred device for sophisticated hearing dose management integrated with the headphones as either an in-cable pod or in the headphones themselves.

Although this may be the most significant application for the present disclosure, there is a broad range of potential implementations.

Rather than integrating hearing dose management with the headphones or its cable, it can be included in the electronic source device (smart-phone, MP3 players etc). Although the overheads of data storage and processing may not be at such a premium, there is still the case for keeping both to reasonable levels. Similar arguments can be applied to wireless hearing devices such as Bluetooth, Bluetooth Smart or WIFI.

Hearing levels cover a vast range of many orders of magnitude. However, hearing loss and hearing perception are both logarithmic in nature. Equal increments of sound level are equal decibel steps. Halving the appropriate noise-exposure can be achieved through a relative 3dB reduction.

The range of hearing-level control also may cover a more moderate range, such as 30dB. To manage precision control over this range necessitates some form of individual device characterisation (eg on a configured network of JFET or MOSFET devices). This would preferably be automatic and part of the manufacturing test process. To match the nature of hearing perception, this would also be based on dB attenuation steps.

The monitoring and control both suggest that some form of logarithmic conversion would be advantageous in the control process. Unfortunately logarithmic conversion, even with look-up tables, places relatively significant demands on device resources in simple low-cost and low-power processors such as microcontrollers.

How to meet the challenges of data and processing demands on simple, low-cost, low-power microcontrollers or other processing devices (even DSPs) where spare resources are constrained is a subject of this disclosure.

**Possible Solutions**

It is possible to implement a completely zero-power and zero-processing solution for hearing dose management.

The first, non-device example is through careful monitoring and control of the sound levels and exposure to them in any particular environment. This approach is generally easiest in the workplace where noise control can be established. Where such control of the noise environment is not practical then alternative measures have to be adopted.

The second example is through zero-power electronic limiting devices such as Canford's (BBC design) in-cable unit. This has a limited ability to manage hearing dose due in part to its short-term timescale (<1 second) and also its operation with signal amplitude rather than energy, open-loop control, and use of non-linear control devices. When combined with careful assessment of the working environment and practice it can help constrain noise exposure. There can be some signal degradation in some situations and it can be constraining in moderate noise environment due to the simple limiting scheme employed.

Proper A-weighting is not practical with this type of device, further reducing its accuracy. There are similar devices available, some more sophisticated and able to work with lower-level signals; but they still suffer from the same disadvantage.

Neither of these solutions is capable of precision monitoring or control of hearing dose levels, and so will either necessitate additional management steps to ensure safe listening, or safe levels are achieved alongside significant constraints on the short-term high levels.

There are some higher-powered solutions using Digital signal processing (DSP) technology; these can be used where power, cost and size requirements are not so demanding. They need larger than desirable batteries or are integrated into another unit such as a contact-centre desk-top unit. The present disclosure could be applicable to them to help reduce processing and data demands.

**Summary**

This disclosure makes the best use of the format of hearing dose related regulation and hearing health recommendations and the factors that contribute to hearing loss through dose rather than instantaneous exposure. In general, average exposures in the long-term need to be constrained to lower levels than in the short-term. If the short-term exposures are controlled to not exceed one level, then the longer-term exposures can be controlled to not exceed another, lower, level.

Using the EU regulatory scheme as an example, 1 second exposure to a noise level of 100dBA SPL is equivalent to 10 second exposure at 90dBA SPL or 100sec at 80dBA SPL. It is therefore necessary to respond more rapidly for high-level sounds than lower-level, whether response is in terms of warnings or sound-reducing action.

This approach allows a parallel set of hearing-dose-management processes to be employed, each operating over different timescales and looking at different levels of energy. The shortest-term process can focus on high-level dose-contributions, using the highest sample rate. Forming a temporal filter at this high data rate such as a running average would need a relatively small number of samples. Any contribution to controlling hearing level could be based on a threshold appropriate for this timescale.

If the formed averages in this process form the samples for the next process, again a relatively small number of samples would be required to cover a longer time period. This can be replicated with each following process using some form of average from its predecessor and hence is able to cover a longer time period with relatively few samples. The last process could cover a whole day, or even a whole week if an alternative, week-long reference is used.

Each of these processes can thereby contribute to the overall assessment of hearing-dose-contribution over an extended period such as a day, but utilising a very small amount of data and greatly reduced processing requirement. Each of these processes could also contribute to an overall control mechanism to constrain hearing levels to within appropriate limits.

Additional sophistication can include feedback from the longer-term to shorter-term processes to ensure that short-term responses take account of the whole-day dose situation.

Further sophistication can include predictive processes to anticipate the likely hearing dose over the future working period.

Such processes can be implemented in hardware, embedded code in a low-power, low-cost microcontroller, as a thread on a multi-tasking digital signal processor (DSP) in any device associated with generation and transport of the sound material to headphones or in the headphones themselves. This could be as an "app" on a suitable platform such as Android, iOS or Windows, or in any other configuration.

To implement the logarithm-based control loop for stability and precision, the above scheme is augmented with a novel form of logarithmic conversion and a matching device calibration scheme.

An efficient logarithmic approximation process is used to compare the ratio of signal to a threshold; this yields a number proportional to the log ratio. All subsequent response operations can then be based on dB. To match this scheme, the attenuating device (e.g. JFET) is individually calibrated in circuit to establish the control voltage required to achieve small dB steps of attenuation. This can be implemented during manufacturing test, and used to generate a look-up table to translate the dB response to a specific level of control voltage to achieve the desired attenuation.

This disclosure greatly simplifies the overall hearing dose management monitoring and control.

Examples are described below, with reference to the accompanying drawings.

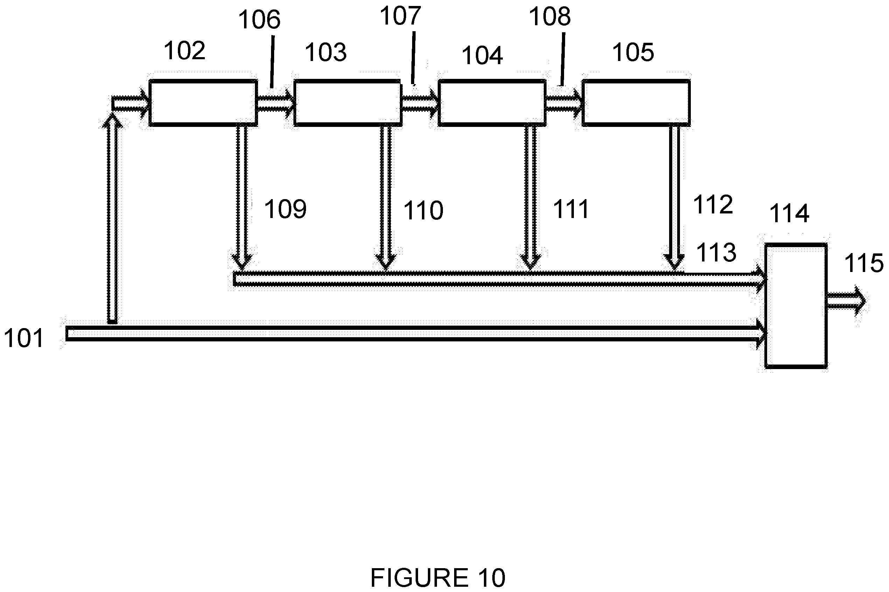

There are provided cascaded hearing dose management processing elements. There is provided an input sound signal (101), typically digital samples at a few Hz from a preprocessor. These are fed to the first cascaded hearing-dose processor (102) which has an output (106) going to the next hearing-dose processor (103) as well as a contributory signal to request attenuation (109). This example has four cascaded processes (102, 103, 104, 105) with four contributory attenuation signals (109, 110, 111, 112) combining to form an overall attenuation control signal (113) which attenuates the input signal in a unit (114) to form an output signal (115). **Figure 10** shows an example of cascaded hearing dose management processing elements.

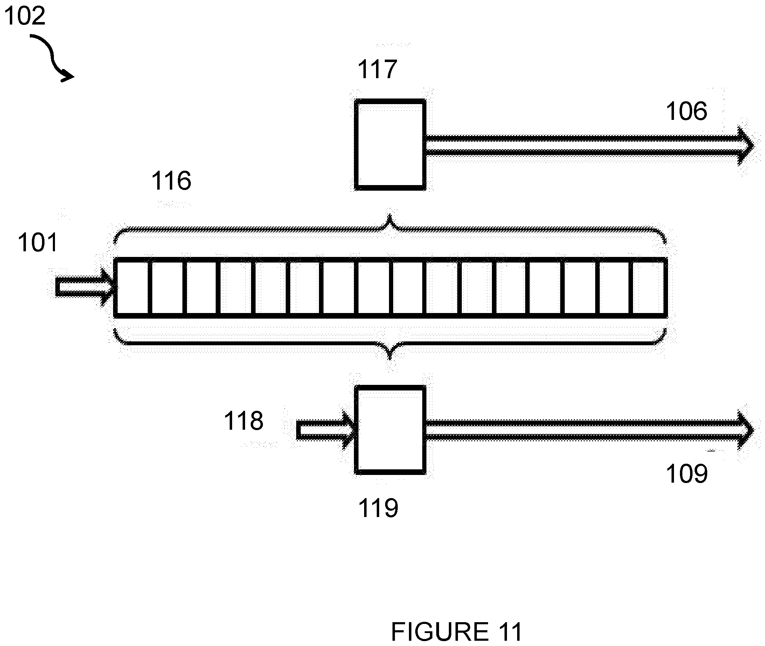

We provide further detail of a single HDM processing element reference. There are provided input sound signal samples (101). A time-series of samples are provided (116), such as could be held in a shift register or memory. A process (117) is provided, such as averaging applied to samples (116) to form an output (106) to the next cascaded hearing dose processor element. A reference or threshold (118) is provided to be used for this particular hearing dose processing element. A second process (119), such as described by the equations in the detailed description, is provided which is performed on the samples (116) in conjunction with the reference (118) to form a contribution (109) to the attenuation control signal. **Figure 11** shows an example of further detail of a single HDM processing element reference (102) in **Figure 10.**

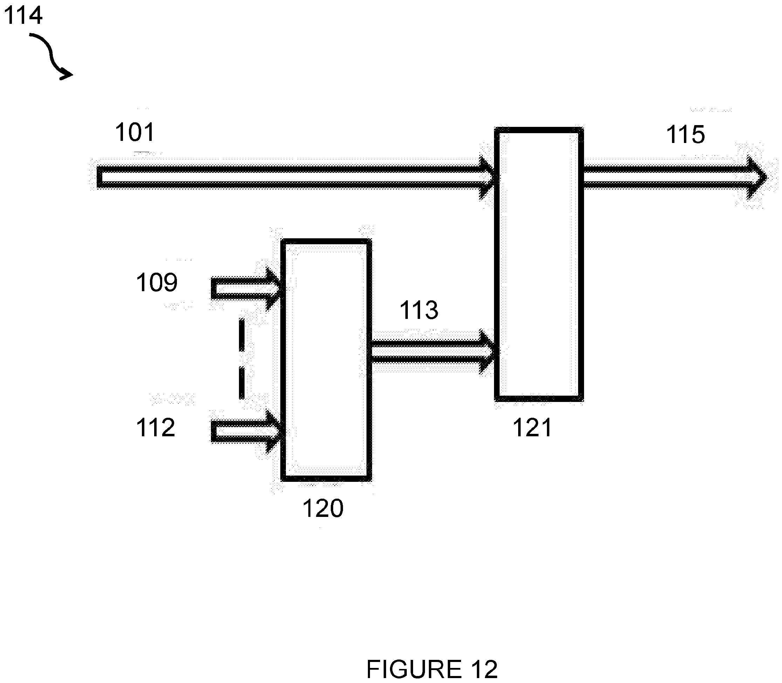

A unit (114) receives input sound signal samples (101). A set of contributions (109)-(112) from hearing dose processing elements are provided to the overall attenuation control signal (113). A process (120) of combining those contributions, which could be addition, is provided. A controlled attenuator (121) acts on the overall attenuation control signal (113) to input sound signal samples (101) to form an output signal (115). **Figure 12** shows an example of detail of the output processing, which illustrates unit (114) in **Figure 10.**

**Detailed Description**

**Dose Monitoring**

As an example, and as most appropriate for the lowest possible data and power requirement, the day could be divided into 16 periods of 90 minutes, the most recent period of 90 minutes could be subdivided into 16 periods of 337.5 seconds; the most recent period of 337.5 sec can be subdivided into 16 periods of approximately 21 seconds. This can be continued down to the chosen sampling rate of the sound signal which could be every 1.3 seconds (using another 16-divider). Such a configuration would need only 64 samples of hearing dose to cover the whole day. Processing would need to occur at an average rate of just over 1/1.3 Hz. An example of these four cascading processes is illustrated in **Figure 10.**

Each process can monitor dose contributions at a suitable rate and create an appropriate response. In this example, the fastest process could sample dose contributions every 1.3 seconds and compare them with a relatively high threshold, say corresponding to 95dB. If the dose contributions represent levels exceeding this threshold, the response could be to introduce attenuation. The most recent 16 samples could be held in a circulating buffer as illustrated in **Figure 11.**

The next slower process could use the same technique but taking in samples into its 16-circulating buffer at a slower rate of ~21 seconds. Each of its 16 samples can be the average of all 16 samples of the fastest process. Its threshold can be lower than the faster process as it is dealing with a longer time period.

This continues for each process until the last covers the whole day of 24 hours and operates with the lowest threshold of all.

The responses (requests for attenuation) can be simply summed or weighted and summed to form the consolidated response. This can be used to control signal attenuation or the intensity of request to the user to take action.

Possible equations for each process could be of the form:

If dose>threshold: Increase attenuation by function(dose/threshold).

If dose<threshold: Reduce attenuation by function(dose/threshold) unless attenuation = 0.

Function(dose/threshold) could take various forms depending on implementation. One example would be: Attenuation change (dB) = k(dose (dB) - threshold dB)), where k is a constant.

Each process can thereby generate an attenuation change signal which is zero or positive. A simple implementation could then sum the contributions to changes in attenuation from all process to form an overall attenuation control.

A more sophisticated approach which better protects the user from excessive dose levels is to employ feedback from slower to faster processes. As an example, the slowest process can compare the dose accumulated during the previous 24 hours with the day's limit. If the accumulated dose over this period is significant relative to the permitted limit, this can be used to reduce the threshold of its preceding (faster) process. This can be cascaded between all the processes until the fastest process also has its threshold reduced.

A possible equation for the threshold of the second to fastest process could be:

$$Threshold = maxthreshold * (1 - 24hourdose/24hourdoselimit).$$

An improved equation prevents a complete shut-off (threshold = zero) through holding some reserve of hearing dose:

$$Threshold = maxthreshold - (maxthreshold-minthreshold) * (24hourdose / 24hourdoselimit).$$

As all monitoring is historical and cannot make any predictions about the future, it is preferable to ensure adequate reserve of hearing dose is available to cater for present use throughout the day. One simple method is to set each process to have a threshold set at an appropriate level. As an example, if the fastest process involved an average of 21 seconds, this is 1/4096 of the day. If the hearing dose limit over 8 hours is 85dBA SPL, the limit this period if only 21 seconds of sound exposure were involved over the day is notionally 116dBA SPL. Setting the threshold for this process to perhaps 25dB below this notional level can ensure that the following process has time to provide its own contribution to attenuation control. Further sophistication can involve prediction based on past noise-exposure patterns (over several days), or from a series of pre-selected hearing dose profiles for the day.

**Dose Control**

For the purposes of a closed-loop control system, there only needs to be an approximation for transforming hearing dose levels into dB-like logarithmic form; an example target is 0.3dB. Similarly, there only needs to be a finite number of steps in any calibration table of the attenuating-device; an example target is 0.5dB steps.

To form an approximate logarithm of a signal in binary form, a first level of approximation is achieved by determining the position of the most significant bit (attains result within +/-3dB; it is assumed signal represents power rather than voltage). This is very simple to achieve in hardware or fixed-point microcontroller code. This will be described in terms of microcontroller code for the remainder of this document.

In a similar way, to determine a log-ratio, such as the ratio of a signal with threshold in terms of dB, a first approximation when both are represented by fixed-point unsigned binary numbers is to count the number of leading zeroes for each and then subtract one from the other. This is the first approximation for a log of the ratio to base 2.

In the above example of a log-ratio, a significant improvement in accuracy with minimal additional processing overhead can be achieved. Taking the next few bits (example could be 3) after the leading 1 for each of signal and threshold, concatenating them (eg into 6 bits) and using this as a look-up reference for a look-up table of signed constants which can be added to the first approximation to give a more accurate result.

Table 1 shows how the look-up table could be constructed. The signal level shifted to the left till most significant bit is 1 yields the right hand 3 bits of concatenation (the table index) from the next 3 most significant bits. The threshold level does the same to yield the left 3 bits of concatenation.

Table 1 - Example Look-up table

| Concatenation | Decimal equivalent | Decimal adjustment | Binary log shift |
|---|---|---|---|
| 000000 | 0 | 0 | 0 |
| 000001 | 1 | 3 | 0.17 |
| 000010 | 2 | 5 | 0.32 |

(continued)

| Concatenation | Decimal equivalent | Decimal adjustment | Binary log shift |
|---|---|---|---|
| 000011 | 3 | 7 | 0.46 |
| 000100 | 4 | 9 | 0.58 |
| 000101 | 5 | 11 | 0.7 |
| 000110 | 6 | 13 | 0.81 |
| 000111 | 7 | 15 | 0.91 |
| 001000 | 8 | -3 | -0.17 |
| 001001 | 9 | 0 | 0 |
| 001010 | 10 | 2 | 0.15 |
| 001011 | 11 | 5 | 0.29 |
| 001100 | 12 | 7 | 0.42 |
| 001101 | 13 | 8 | 0.53 |
| 001110 | 14 | 10 | 0.64 |
| 001111 | 15 | 12 | 0.74 |
| 010000 | 16 | -5 | -0.32 |
| 010001 | 17 | -2 | -0.15 |
| 010010 | 18 | 0 | 0 |
| 010011 | 19 | 2 | 0.14 |
| 010100 | 20 | 4 | 0.26 |
| 010101 | 21 | 6 | 0.38 |
| 010110 | 22 | 8 | 0.49 |
| 010111 | 23 | 9 | 0.58 |
| 011000 | 24 | -7 | -0.46 |
| 011001 | 25 | -5 | -0.29 |
| 011010 | 26 | -2 | -0.14 |
| 011011 | 27 | 0 | 0 |
| 011100 | 28 | 2 | 0.13 |
| 011101 | 29 | 4 | 0.24 |
| 011110 | 30 | 6 | 0.35 |
| 011111 | 31 | 7 | 0.45 |
| 100000 | 32 | -9 | -0.58 |
| 100001 | 33 | -7 | -0.42 |
| 100010 | 34 | -4 | -0.26 |
| 100011 | 35 | -2 | -0.13 |
| 100100 | 36 | 0 | 0 |
| 100101 | 37 | 2 | 0.12 |
| 100110 | 38 | 4 | 0.22 |
| 100111 | 39 | 5 | 0.32 |
| 101000 | 40 | -11 | -0.7 |

(continued)

| Concatenation | Decimal equivalent | Decimal adjustment | Binary log shift |
|---|---|---|---|
| 101001 | 41 | -8 | -0.53 |
| 101010 | 42 | -6 | -0.38 |
| 101011 | 43 | -4 | -0.24 |
| 101100 | 44 | -2 | -0.12 |
| 101101 | 45 | 0 | 0 |
| 101110 | 46 | 2 | 0.11 |
| 101111 | 47 | 3 | 0.21 |
| 110000 | 48 | -13 | -0.81 |
| 110001 | 49 | -10 | -0.64 |
| 110010 | 50 | -8 | -0.49 |
| 110011 | 51 | -6 | -0.35 |
| 110100 | 52 | -4 | -0.22 |
| 110101 | 53 | -2 | -0.11 |
| 110110 | 54 | 0 | 0 |
| 110111 | 55 | 2 | 0.1 |
| 111000 | 56 | -15 | -0.91 |
| 111001 | 57 | -12 | -0.74 |
| 111010 | 58 | -9 | -0.58 |
| 111011 | 59 | -7 | -0.45 |
| 111100 | 60 | -5 | -0.32 |
| 111101 | 61 | -3 | -0.21 |
| 111110 | 62 | -2 | -0.1 |
| 111111 | 63 | 0 | 0 |

For a specific example (using 8-bit data) of binary 00100000 for signal and 00001001 for the threshold: After shifting left till most significant bit is 1, these become 10000000 and 10010000 with 2 shifts for signal and 4 shifts for threshold. Signal (power) is thereby approximately binary 4 times the threshold, and the threshold shift-signal shift (4-2) yields 2 which is the binary for the log ratio to base 2 (Log base 2 of 4 = 2). This estimation is 6dB. For the purposes of scaling, this is shifted left by 4 (multiplied by 16) to make room for the adjustment resulting a shifted first estimate of 32 (00100000).

Taking the next 3 bits of signal and threshold, 000 and 001, these concatenate to form 001000 which addresses the 8th row of table and yields the adjustment of -3 representing -0.17dB.

An improved estimation in this example format is formed by adding the adjustment to the original estimation, 2 (00000010) shifted left by 4 = 32 (00100000) - 3 (00000011) = 27 (00011101). The improved estimation of binary log is equivalent to an actual ratio of 3.5125 whereas the actual ratio is 3.5556. This represents a significant improvement over the initial estimation and uses very little processing resource.

The matching arrangement for calibrating the attenuation device is illustrated in Table 2.

Table 2: Calibration table data for embedding in processing device (only a few rows shown for illustration).

| Index | dB attenuation | Control voltage left (mV) | Control voltage right (mV) |
|---|---|---|---|
| 0 | 0 | 0 | 0 |
| 1 | 0.5 | 150 | 170 |

(continued)

| Index | dB attenuation | | Control voltage left (mV) | Control voltage right (mV) |
|---|---|---|---|---|
| 2 | 1 | | 180 | 195 |
| | | | | |
| 127 | 63.5 | 3015 | | 2950 |

**Requirements for Pre-Processing**

This disclosure pre-supposes a moderately low sampling of the ongoing hearing dose contribution. As previously stated the full signal bandwidth cannot be taken into simple low-cost microcontrollers and requires pre-processing. Alternative schemes include digital sub-sampling and analogue pre-processing, and these will be briefly described for completeness of this document.

Digital sub-sampling involves taking digitized samples of the analogue sound signal; although each sample cannot be related to the current contribution to hearing dose, enough samples would eventually convey information about the general hearing dose level. This has distinct disadvantages for short-term events but can nevertheless provide some level of hearing dose management over the longer period. Each sample would be positive or negative, and would represent voltage rather than energy; thus squaring each sample would give a hint of the energy contribution. Squaring each sample introduces some processing overhead for such a scheme, especially if the sample rate is high enough for good short-term dynamic performance of hearing dose monitoring and control. No A-weighted filtering is possible in such a scheme, but, in a variant not covered by the present invention, it could potentially be applied prior to the point of digitisation.

Another option, which is also outside the scope of the present invention, is the use of analogue pre-processing prior to digitisation. The three sub-processes of A-weight filtering followed by magnitude generation, followed by low-pass filtering can bring the sample rate down to close to 1Hz without excessive loss of data. As stated, these samples would be voltage-based and hence need squaring prior to use as dose-contribution measurement; nevertheless, as the sampling rate could be much lower than for digital sub-sampling, significant reduction in the processing requirement can be achieved.

**Concepts**

The following concepts are illustrative and do not define the scope of the present invention.

1. A particular method of accurately assessing long-term hearing dose in relatively simple processing devices through the use of cascaded processing elements operating with different times cales.

2. Method of concept 1, where the assessed dose is used to control hearing levels as in a hearing dose management system.

3. Method of concepts 1 or 2, where at least one of the processes contributes to the overall control process based on a combination of its timescale and appropriate reference threshold.

4. Method of any of concepts 1 to 3, where each of the cascaded processes involves forming a temporal filter based on a number of samples, such as a running average.

5. Method of any of concepts 1 to 4, where the output of a cascaded process forms the input to the next process.

6. Method of any of concepts 1 to 5, where the output of the slowest process can moderate the reference threshold of previous cascaded processes.

7. A method for efficient processing of data and control whereby an efficient log estimation is used with little impact on any processing element's resources.

8. A complementary method or apparatus of encapsulating calibration data whereby efficient access to it data during control loop operations is achieved.

9. Automatic individual unit calibration process so as to achieve the above calibration data during the manufacturing and test process.

**Section Four - Examples**

Aspects of the invention are exemplified by way of a series of examples, each bringing out an aspect which does not define the scope of the invention.

The first example is an app resident on a smartphone being used with known earpieces. The app is able to estimate noise-dose contributions as and when a program is played. It is able to analyse the program content, apply appropriate filtering and averaging and using pre-existing knowledge of the earpiece sensitivity is able to complete the estimation. Section Two provides description relating to what may be done with the data.

The second example is a similar app, but with a different set of earphones. Although the above app is able to analyse the program content, output level and play time, the missing information for noise-dose estimation is the earpiece sensitivity. One aspect of this disclosure is the facility to obtain this information through a plethora of machine-readable data. Examples include QR codes on the earpiece product, its packaging or other such as a warranty card. Section Two provides descriptions relating to obtaining sensitivity data.

The third example is the use of a wireless headset physically unconnected with the smartphone, and perhaps not even playing content from the smartphone. A more complete example is where embedded code in the wireless headset is able to estimate the noise-dose contributions having intimate knowledge of what is entering the actual earpiece and its sensitivity. This data is communicated either directly or indirectly to the smartphone where its app (partially described above) is able to incorporate the data in an overall user-noise-dose record. Note that noise-dose data can have low bandwidth (perhaps one sample per second), which makes such communication easier through a variety of techniques as for example Bluetooth.

The fourth example is where the smartphone app partially described above communicates with a website, on which a registered user can accumulate their personal noise-dose record across several devices (smartphones, PCs, tablets etc).

The fifth example is where the program content source is from a device without web-access but which is able to communicate with a smartphone. If it has a way of determining noise dose or even the A-weighted energy being delivered to the earpiece, this data can be sent to the smartphone to augment the overall personal noise-dose record. The smartphone app partially described above can use the above way of securing the earpiece sensitivity data where necessary.

The sixth example applies where the source device is not able to communicate with the smartphone; a dongle inserted between headset and source device can provide the necessary analysis of signals driving the earpiece and communicate through a variety of ways (eg Bluetooth) with the smartphone. Again, the previous ways of determining earpiece sensitivity apply.

The seventh example is where earpiece sensitivity data is not available for a given earpiece type. This may be due to poor manufacturing data, loss of packaging etc. Using the smartphone and an acoustic adapter, the earpiece's sensitivity can be estimated using the smartphone microphone. One aspect of the app is to facilitate alignment of the acoustic adapter using markings on the screen; this correctly aligns the adapter with the specific location of microphone on a particular type of smartphone.

An eighth example is where noise-dose data accumulation is compared with regulatory or recommended safe levels, and, if the option has been enabled, use this to control the source device output levels to ensure safe sound over the day. Level control may be effected at any convenient point in the present configuration of equipment.

A ninth example is where any of the devices estimating noise-dose uses a more simple method than the full filtering plus averaging process, due to constraints on processing power. Although this may introduce some uncertainty into the overall noise-dose assessment, it could represent a distinct improvement on what would otherwise be the case. Examples of this include subsampling with or without A-weighted filtering, simpler filtering, or even no filtering. An aspect is that the estimation is accepted in the overall noise-dose assessment, but this part of the data is tagged with an uncertainty code to represent how the estimation could under certain circumstances deviate from full noise-dose estimation.

A tenth example is where the smartphone is able to improve any estimation tagged with an uncertainty code; this is most easily achieved where it is the program source, such as to a wireless headset. Parallel process of a good A-weighted energy estimation of signal being sent to the headset as well as a similar process used by the headset will enable the smartphone to correct any errors. The significance here is that volume controls mounted on wireless headsets could then be taken into account by the smartphone in computing noise dose.

An eleventh example is where a remote device such as a wireless headset is able to send information on volume setting etc to the smartphone, enabling the smartphone to perform full analysis on the signals being sent to the headset including its volume setting.

A twelfth example is where the smartphone app determines the aspect of current noise-dose estimation which is most uncertain. This would include the above mentioned uncertainty codes as well as the situations where an earpiece is being used with unknown sensitivity.

A thirteenth example is one in which software, delivered in the headphone or headphone accessory and Smartphone, and a web App, capture exposure and present data and provide protection, in which exposure is obtained from measuring sound time, volume and density.

A fourteenth example is one in which the noise dose data of the user recorded on the smartphone includes noise dose data relating to the user, provided by a user self-assessment. The user self-assessment may be provided on the smartphone, or it may be performed on another computing device and then sent to the smartphone for inclusion in the noise dose data of the user recorded on the smartphone. User self-assessment is useful because it may not always be possible for devices to estimate noise dose exposure of a user with reasonable accuracy. So for example in a user self-assessment a user may report that in the previous 24 hours they attended a rock concert for 2 hours and traveled on public transport for 1 hour, and then an estimate for the additional noise dose exposure can be added to the record of the user's noise dose exposure record by processing the self-assessment data provided by the user. This is preferable to including no estimate at all of the user's noise dose exposure when devices are not monitoring the user's noise dose exposure.

## Section Five - Calibration

A significant complication for HDM is centred on the desire to ensure any particular earpiece is matched to an HDM algorithm. Such matching enables the signals going to earpiece (typically voltage) to be related to sound levels reaching the ears and thereby the hearing dose that results from them. The matching can be expressed as sensitivity, although impedance can also be a useful factor.

A scheme for automated calibration of earpieces with particular devices is provided. A calibration kit is supplied with an earpiece, smartphone etc, or separately as part of an HDM algorithm kit. The kit includes a calibrated earpiece and an acoustic adapter. A variation is for a stand-alone calibrated sound source to substitute for the calibrated earpiece. The calibrated earpiece is connected to the smartphone (or other device) and with the adapter placed over the in-built microphone. An app is used to generate a signal appropriate for calibration, and to relate the signal from the microphone to the calibration signal. This calibrates the smartphone's internal microphone. Replacing the calibrated earpiece with any earpiece intended to be used allows the same app to establish the sensitivity of that earpiece; this allows any HDM app to accurately determine dose contributions from the signal levels going to the earpiece.

The first half of the process (microphone calibration) may only need to be performed once per smartphone; the calibration result can then be used for any subsequent earpiece calibration. The calibration result can also be used to forward the internal microphone's calibration to any app operating as a sound level meter. If the smartphone's internal microphone has a known sensitivity, this step can be omitted.

### Earpiece Calibration Database

There is some uncertainty about the sensitivity of a particular earpiece. Published data for any particular type of earpiece is often ambiguous and leaves the user making assumptions that could result in NIHL as the earpiece may be significantly more sensitive than the data suggests. Manufacturing necessarily results in performance variations, sensitivity being relevant in this application, and thereby providing deviations from published data. To calibrate each earpiece type, and several samples of each type to provide a statistical distribution, is a prohibitive task once the earpieces are manufactured and physically distributed.

This innovation relates to a publicly accessible earpiece calibrator linked to a database; earpieces owned by members of the public can be placed on the calibrator and the resultant sensitivity, together with the earpiece type, can be added to a database. Over time a usable database may be built-up that not only provides known sensitivity data for each earpiece in use, but also indicates its manufacturing spread.

To encourage use of such a calibrator, it can be made available at events such as roadshows, festivals, schools as a travelling educational event, or university "freshers" events. With sufficient automation, this can be operated by members of the public rather than trained technicians; calibration stations can then be placed in suitable public locations such as libraries, or retail operations such as public areas in shopping malls or in audio-related retail outlets.

Alongside earpiece calibrations can be a calibrator for smartphone internal microphones, being used to establish a database of typical sensitivities and for manufacturing spreads in these smartphone internal microphones.

### Acoustic Adapter:

To calibrate either an earpiece or a smartphone's internal microphone, it is important to guide the sound from source device to the detecting device in a reproducible way that can be related to the relationship between earpiece and ear. The ear itself plays a significant part in this relationship, and in some way must be represented by the acoustic adapter. The acoustic adapter shape and material are both important. Suitable shapes and materials would be clear to those skilled in the art. Two innovations for the acoustic adapter are described here.

Firstly, if fabricated from material that can also be used as packaging, the acoustic adapter can be moulded in the packaging material itself to achieve very-low-cost manufacturing. This acoustic adapter could be for a smartphone where the packaging shape is likely to match the smartphone body; this gives the potential for a suitable shape for the acoustic adapter that accurately mates with the internal microphone and allows an earpiece to be correctly positioned.

This acoustic adapter could also be for an earpiece, accurately mating with it and providing correct positioning for the microphone.

Secondly, the above smartphone and earpiece moulded parts may each have a common interface, enabling a smartphone-specific microphone acoustic adapter to correctly mate with an earpiece-specific acoustic adapter. If an open-source definition of the common interface is provided, this could encourage manufacturers of either smartphones or earpieces to provide appropriate features in their packaging.

In addition to the above, third party suppliers may also wish to supply suitable acoustic adapters.

**NIHL Predictor:**

One of the difficulties in persuading users to listen at appropriate hearing levels is the lack of meaningful yet subjective association between any particular hearing level and the likely consequence in hearing loss. This innovation provides a tool that makes the likely NIHL resulting from present levels very clear.

It is possible to estimate the likely hearing loss at a given future date or age based on assumptions such as daily listening levels and times. This likely hearing loss can be represented as a change in hearing sensitivity over the frequency range, and can be used to filter any material being listened to dramatically show NIHL. An HDM-based system can produce an assessment of listening habits and resulting contributions to hearing dose; this can then be used to predict future NIHL. Such a system (e.g. app on a smartphone) may incorporate a NIHL-predictor function that demonstrates the likely effect on hearing quality, at the touch of a (eg. soft) button. Options for age or future date can be included, as can the alternative effect on NIHL if various remedial actions are taken such as reducing the levels of time of noise exposure.

To help drive the message home for the individual user, an additional function can be incorporated in an HDM system to self-assess the preset hearing sensitivity. This can use various interactive techniques, one being responding to particular words or tones within a background of noise.

There are several celebrities who have suffered NIHL and are concerned to help prevent others from the same. To further drive the NIHL message home, the hearing profiles of such celebrities can be placed in a database of hearing damage profiles. These can be made available on-line so that anyone can hear the effects with various samples of music, speech etc. Incorporation of such profiles in an app will allow these consequences to be heard through one's own choice of material.

**Note**

It is to be understood that the above-referenced arrangements are only illustrative of the application for the principles of the present invention.

**Claims**

1. A portable programmable device including a battery, a memory, a screen and a terminal connectable to earpieces, the device including in the memory a calibration file, parameter or parameters relating to audio sensitivity of the earpieces, the device being configured to play media data including audio, and to provide audio output to the earpieces, the device being further configured to, using the calibration file, parameter or parameters, calculate a noise dose relating to a sound exposure of a user resulting from audio output provided to the earpieces, and to record the noise dose on the device, wherein the device is configured to adjust audio output level in response to:

   (a) audio content included in played media data;
   (b) the calibration file, parameter or parameters, and
   (c) noise dose data of the user recorded on the device; **characterised in that** the device is configured to prompt the user to identify the earpieces when the earpieces are connected to the device, and to calculate the noise dose using subsampling from signals going to the earpieces.

2. Device of Claim 1, wherein the device is configured to adjust audio output level so as to reduce audio output to safe levels for the user, or wherein the device is further configured to adjust audio output level in response to a comparison of the noise dose with regulatory or recommended safe levels.

3. Device of any previous Claim, wherein the device is further configured to adjust audio output level in response to a measure of ambient noise recorded using a microphone of the portable programmable device, or wherein the noise dose is calculated including using a measure of ambient noise recorded using a microphone of the portable programmable device, or wherein the noise dose is calculated using a measure of audio output volume, a measure of the relationship between the audio output level and energy, and duration.

4. Device of any previous Claim, wherein a recorded noise dose is tagged with an uncertainty code representing how the estimation may deviate from full noise-dose estimation.

5. Device of any previous Claim, wherein the noise dose data of the user recorded on the device includes noise dose data relating to the user, received from a web server.

6. Device of any previous Claim, wherein the device is connectable to a plurality of different earpieces, the device including a plurality of calibration files or parameters corresponding to respective earpieces, in which the calibration file or parameters used to adjust the audio output level correspond to the earpieces.

7. Device of any of Claims 1 to 6, wherein the earpieces are identifiable on the device by manually entering a unique identity of the earpieces on the device, or wherein the earpieces are identifiable on the device by scanning an optical barcode of the earpieces, such as a QR code, such as by scanning product packaging or similar, such as a guarantee card, using a camera included in the portable programmable device.

8. Device of any of Claims 1 to 7, wherein the calibration file, parameter or parameters of the earpieces are receivable on the device by scanning an optical barcode of the calibration file, parameter or parameters, such as a QR code, such as by scanning product packaging or similar, such as a guarantee card, using a camera included in the portable programmable device.

9. Device of any previous Claim, wherein the adjustment of audio output level is an adjustment of audio output level as a function of audio frequency.

10. Device of any previous Claim, wherein the device is configured to provide user noise dose data using an internet connection to a website including an account relating to an accumulated noise exposure of the user.

11. Device of any previous Claim, wherein the device is configured to present on the screen an estimate of the likely hearing loss at a given future date or user age based on recorded user noise dose, or wherein the device is configured to demonstrate the likely effect of hearing loss on hearing quality, in response to a touch of a (eg. soft) button, or wherein the device includes a setting selectable to provide automatic hearing-dose-management.

12. Device of any previous Claim, wherein the device is configured such that a logarithmic approximation process is used to compare the ratio of signal to a threshold, which yields a number proportional to a log ratio, and wherein subsequent response operations are based on dB, or wherein the device includes cascaded hearing dose management processing elements, in which there is provided an input sound signal, which is fed to a first cascaded hearing-dose processor which has an output going to a next hearing-dose processor as well as a contributory signal to request attenuation, in which cascaded processes with corresponding contributory attenuation signals combine to form an overall attenuation control signal which attenuates the input signal in a unit to form an output signal.

13. Device of any previous Claim, wherein the device is a smartphone.

14. Method of adjusting audio output level on a portable programmable device, the device including a battery, a memory and a terminal connectable to earpieces, the device including in the memory a calibration file, parameter or parameters relating to an audio sensitivity of the earpieces, the device configured to play media data including audio, the method comprising the steps of:

   (i) providing audio output to the earpieces,
   (ii) calculating using the calibration file, parameter or parameters a noise dose relating to sound exposure of a user resulting from audio output provided to the earpieces;
   (iii) recording the noise dose, and
   (iv) adjusting audio output level in response to:

      (a) audio content included in played media data;
      (b) the calibration file, parameter or parameters, and
      (c) noise dose data of the user recorded on the device,

**characterised by**:

the device prompting the user to identify the earpieces when the earpieces are connected to the device, and calculating the noise dose using subsampling from signals going to the earpieces.

15. Computer program product executable on a portable programmable device, the device including a battery, a memory and a terminal connectable to earpieces, the computer program product executable on the device to adjust audio output level, the device including in the memory a calibration file, parameter or parameters relating to an audio sensitivity of the earpieces, the device configured to play media data including audio, the computer program product executable on the device to:

(i) provide audio output to the earpieces,
(ii) calculate using the calibration file, parameter or parameters a noise dose relating to sound exposure of a user resulting from audio output provided to the earpieces;
(iii) record the noise dose, and
(iv) adjust audio output level in response to:

(a) audio content included in played media data;
(b) the calibration file, parameter or parameters, and
(c) noise dose data of the user recorded on the device,

**characterised by** the computer program product being executable on the device to:

prompt the user to identify the earpieces when the earpieces are connected to the device, and
calculate the noise dose using subsampling from signals going to the earpieces.


**Patentansprüche**

1. Tragbare, programmierbare Vorrichtung, die eine Batterie, einen Speicher, einen Bildschirm und einen Anschluss, der mit Ohrhörern verbunden werden kann, umfasst, wobei die Vorrichtung in dem Speicher eine Kalibrierungsdatei, einen oder mehrere Parameter in Bezug auf die Audioempfindlichkeit der Ohrhörer umfasst, wobei die Vorrichtung dazu konfiguriert ist, Mediendaten abzuspielen, die Audio umfassen, und eine Audioausgabe an die Ohrhörer bereitzustellen, wobei die Vorrichtung ferner dazu konfiguriert ist, unter Verwendung der Kalibrierungsdatei, des Parameters oder der Parameter eine Geräuschdosis in Bezug auf eine Geräuschbelastung eines Benutzers, die sich aus einer an den Ohrhörern bereitgestellten Audioausgabe ergibt, zu berechnen, und die Geräuschdosis auf der Vorrichtung aufzuzeichnen, wobei die Vorrichtung dazu konfiguriert ist, den Audioausgabepegel einzustellen als Reaktion auf:

(a) den in den abgespielten Mediendaten umfassten Audioinhalt;
(b) die Kalibrierungsdatei, den oder die Parameter, und
(c) in der Vorrichtung aufgezeichneten Geräuschdosisdaten des Benutzers;

**dadurch gekennzeichnet, dass** die Vorrichtung dazu konfiguriert ist, den Benutzer aufzufordern, die Ohrhörer zu identifizieren, wenn die Ohrhörer mit der Vorrichtung verbunden sind, und die Geräuschdosis unter Verwendung von Unterabtastung von zu den Ohrhörern gehenden Signalen zu berechnen.

2. Vorrichtung nach Anspruch 1, wobei die Vorrichtung dazu konfiguriert ist, den Audioausgangspegel so einzustellen, dass die Audioausgangspegel auf für den Benutzer sichere Pegel reduziert wird, oder wobei die Vorrichtung ferner dazu konfiguriert ist, den Audioausgangspegel als Reaktion auf einen Vergleich der Geräuschdosis mit den vorgeschriebenen oder empfohlenen sicheren Pegeln einzustellen.

3. Vorrichtung nach einem der vorhergehenden Ansprüche, wobei die Vorrichtung ferner dazu konfiguriert ist, den Audioausgangspegel als Reaktion auf ein mit einem Mikrofon der tragbaren programmierbaren Vorrichtung aufgezeichnetes Maß für Umgebungsgeräusche einzustellen, oder wobei die Geräuschdosis unter Verwendung eines mit einem Mikrofon der tragbaren programmierbaren Vorrichtung aufgezeichnetes Maßes von Umgebungsgeräuschen berechnet wird, oder wobei die Geräuschdosis unter Verwendung eines Maßes für die Audio-Ausgangslautstärke, eines Maßes für das Verhältnis zwischen dem Audioausgangspegel und Ausgangsenergie und der Dauer berechnet wird.

4. Vorrichtung nach einem der vorhergehenden Ansprüche, wobei eine aufgezeichnete Geräuschdosis mit einem Unsicherheitscode markiert ist, der darstellt, wie die Schätzung von der vollständigen Geräuschdosisschätzung abweichen kann.

5. Vorrichtung nach einem der vorhergehenden Ansprüche, wobei die auf der Vorrichtung aufgezeichneten Geräuschdosisdaten des Benutzers von einem Webserver empfangene Geräuschdosisdaten in Bezug auf den Benutzer umfassen.

6. Vorrichtung nach einem der vorhergehenden Ansprüche, wobei die Vorrichtung mit einer Mehrzahl verschiedener Ohrhörer verbunden werden kann, wobei die Vorrichtung eine Mehrzahl von Kalibrierungsdateien oder Parametern umfasst, die den jeweiligen Ohrhörern entsprechen, wobei die Kalibrierungsdatei oder die Parameter, die zum Einstellen des Audioausgangspegels verwendet werden, den Ohrhörern entsprechen.

7. Vorrichtung nach einem der Ansprüche 1 bis 6, wobei die Ohrhörer auf der Vorrichtung identifizierbar sind, indem eine eindeutige Identität der Ohrhörer manuell auf der Vorrichtung eingegeben wird, oder wobei die Ohrhörer auf der Vorrichtung identifizierbar sind, indem unter Verwendung einer in der tragbaren programmierbaren Vorrichtung umfassten Kamera ein optischer Barcode der Ohrhörer, wie etwa ein QR-Code, gescannt wird, wie etwa durch Scannen einer Produktverpackung oder Ähnlichem, wie etwa einer Garantiekarte.

8. Vorrichtung nach einem der Ansprüche 1 bis 7, wobei die Kalibrierungsdatei, der Parameter oder die Parameter der Ohrhörer auf der Vorrichtung empfangen werden können, indem unter Verwendung einer in der tragbaren, programmierbaren Vorrichtung umfassten Kamera ein optischer Barcode der Kalibrierungsdatei, des Parameters oder der Parameter, wie etwa ein QR-Code, gescannt wird, wie etwa durch Scannen einer Produktverpackung oder Ähnlichem, wie etwa einer Garantiekarte.

9. Vorrichtung nach einem der vorhergehenden Ansprüche, wobei die Einstellung des Audioausgangspegels eine Einstellung des Audioausgangspegels in Abhängigkeit der Audiofrequenz ist.

10. Vorrichtung nach einem der vorhergehenden Ansprüche, wobei die Vorrichtung dazu konfiguriert ist, unter Verwendung einer Internetverbindung zu einer Website, die ein Konto in Bezug auf eine akkumulierte Geräuschbelastung des Benutzers umfasst, Daten über die Benutzergeräuschdosis des Benutzers bereitzustellen.

11. Vorrichtung nach einem der vorhergehenden Ansprüche, wobei die Vorrichtung dazu konfiguriert ist, auf dem Bildschirm eine Schätzung des wahrscheinlichen Hörverlusts zu einem gegebenen zukünftigen Datum oder Alter des Benutzers basierend auf der aufgezeichneten Benutzergeräuschdosis darzustellen, oder wobei die Vorrichtung dazu konfiguriert ist, die wahrscheinliche Auswirkung des Hörverlusts auf die Hörqualität als Reaktion auf die Berührung einer (z.B. weichen) Taste aufzuzeigen, oder wobei die Vorrichtung eine Einstellung umfasst, die ausgewählt werden kann, um eine automatische Hördosierungsverwaltung bereitzustellen.

12. Vorrichtung nach einem der vorhergehenden Ansprüche, wobei die Vorrichtung derart konfiguriert ist, dass ein logarithmisches Näherungsverfahren verwendet wird, um das Verhältnis des Signals mit einem Schwellenwert zu vergleichen, was eine zu einem logarithmischen Verhältnis proportionale Zahl ergibt, und wobei nachfolgende Reaktionsvorgänge auf dB basieren, oder wobei die Vorrichtung kaskadierte Verarbeitungselemente für die Hördosierungsverwaltung umfasst, wobei ein Eingangsschallsignal bereitgestellt wird, das einem ersten kaskadierten Hördosierungsprozessor zugeführt wird, der einen Ausgang aufweist, der zu einem nächsten Hördosierungsprozessor geht, sowie ein beitragendes Signal bereitgestellt wird, um eine Dämpfung anzufordern, wobei sich kaskadierte Prozesse mit entsprechenden beitragenden Dämpfungssignalen verbinden, um ein Gesamtdämpfungssteuersignal zu bilden, das das Eingangssignal in einer Einheit dämpft, um ein Ausgangssignal zu bilden.

13. Vorrichtung nach einem der vorhergehenden Ansprüche, wobei die Vorrichtung ein Smartphone ist.

14. Verfahren zum Einstellen des Audioausgangspegels auf einer tragbaren programmierbaren Vorrichtung, wobei die Vorrichtung eine Batterie, einen Speicher und einen Anschluss, der mit Ohrhörern verbunden werden kann, umfasst, wobei die Vorrichtung in dem Speicher eine Kalibrierungsdatei, einen oder mehrere Parameter in Bezug auf eine Audio-Empfindlichkeit der Ohrhörer umfasst, wobei die Vorrichtung dazu konfiguriert ist, Mediendaten abzuspielen, die Audio umfassen, wobei das Verfahren die Schritte umfasst:

(i) Bereitstellen einer Audioausgabe an den Ohrhörern,

(ii) Berechnen einer Geräuschdosis unter Verwendung der Kalibrierungsdatei, des Parameters oder der Parameter, die sich auf die Schallbelastung eines Benutzers beziehen, die sich aus der an den Ohrhörern bereitgestellten Audioausgabe ergibt;

(iii) Aufzeichnen der Geräuschdosis und

(iv) Einstellen des Audioausgangspegels als Reaktion auf:

(a) Audioinhalte, die in abgespielten Mediendaten umfasst sind;

(b) die Kalibrierungsdatei, den oder die Parameter, und

(c) in der Vorrichtung aufgezeichneten Geräuschdosisdaten des Benutzers,

**gekennzeichnet durch**:

die Aufforderung der Vorrichtung an den Benutzer, die Ohrhörer zu identifizieren, wenn die Ohrhörer mit der Vorrichtung verbunden sind, und

das Berechnen der Lärmdosis unter Verwendung von Unterabtastung von Signalen, die zu den Ohrhörern gehen.

15. Computerprogrammprodukt, das auf einer tragbaren, programmierbaren Vorrichtung ausführbar ist, wobei die Vorrichtung eine Batterie, einen Speicher und einen Anschluss, der mit Ohrhörern verbunden werden kann, umfasst, wobei das Computerprogrammprodukt auf der Vorrichtung ausführbar ist, um den Audioausgangspegel einzustellen, wobei die Vorrichtung in dem Speicher eine Kalibrierungsdatei, einen oder mehrere Parameter, die sich auf eine Audio-Empfindlichkeit der Ohrstücke beziehen, umfasst, wobei die Vorrichtung dazu konfiguriert ist, Mediendaten abzuspielen, die Audio umfassen, wobei das Computerprogrammprodukt auf der Vorrichtung ausführbar ist, um:

(i) eine Audioausgabe an den Ohrhörern bereitzustellen,

(ii) unter Verwendung der Kalibrierungsdatei, des Parameters oder der Parameter eine Lärmdosis in Bezug auf die Schallbelastung eines Benutzers zu berechnen, die sich aus der an den Ohrhörern bereitgestellten Audioausgabe ergibt;

(iii) die Geräuschdosis aufzuzeichnen und

(iv) den Audioausgangspegels einzustellen als Reaktion auf:

(a) den Audioinhalt, der in abgespielten Mediendaten umfasst ist;

(b) die Kalibrierungsdatei, den oder die Parameter, und

(c) in der Vorrichtung aufgezeichneten Geräuschdosisdaten des Benutzers,

**dadurch gekennzeichnet, dass** das Computerprogrammprodukt auf der Vorrichtung ausführbar ist, um:

den Benutzer aufzufordern, die Ohrhörer zu identifizieren, wenn die Ohrhörer mit der Vorrichtung verbunden sind, und

die Lärmdosis unter Verwendung einer Unterabtastung von Signalen, die zu den Ohrhörern gehen, zu berechnen.

## Revendications

1. Dispositif programmable portable comprenant une batterie, une mémoire, un écran et un terminal apte à être connecté à des oreillettes, le dispositif comprenant dans la mémoire un fichier, un paramètre ou des paramètres d'étalonnage concernant la sensibilité audio des oreillettes, le dispositif étant configuré pour lire des données multimédias comprenant de l'audio, et pour fournir une sortie audio aux oreillettes, le dispositif étant en outre configuré pour, en utilisant le fichier, le paramètre ou les paramètres d'étalonnage, calculer une dose de bruit relative à une exposition sonore d'un utilisateur résultant d'une sortie audio fournie aux oreillettes, et pour enregistrer la dose de bruit sur le dispositif, le dispositif étant configuré pour ajuster le niveau de sortie audio en réponse :

(a) au contenu audio inclus dans les données multimédias lues ;

(b) au fichier, au paramètre ou aux paramètres d'étalonnage, et

(c) à des données de dose de bruit de l'utilisateur enregistrées sur le dispositif ;

**caractérisé par le fait que** le dispositif est configuré pour inviter l'utilisateur à identifier les oreillettes lorsque les oreillettes sont connectées au dispositif, et pour calculer la dose de bruit en utilisant un sous-échantillonnage à partir des signaux allant vers les oreillettes.

2. Dispositif selon la revendication 1, dans lequel le dispositif est configuré pour ajuster le niveau de sortie audio de manière à réduire la sortie audio à des niveaux de sécurité pour l'utilisateur, ou dans lequel le dispositif est en outre configuré pour ajuster le niveau de sortie audio en réponse à une comparaison de la dose de bruit à des niveaux de sécurité réglementaires ou recommandés.

3. Dispositif selon l'une quelconque des revendications précédentes, dans lequel le dispositif est en outre configuré pour ajuster le niveau de sortie audio en réponse à une mesure du bruit ambiant enregistré à l'aide d'un microphone du dispositif programmable portable, ou dans lequel la dose de bruit est calculée y compris en utilisant une mesure du bruit ambiant enregistré à l'aide d'un microphone du dispositif programmable portable, ou dans lequel la dose de bruit est calculée en utilisant une mesure du volume de sortie audio, une mesure de la relation entre le niveau de sortie audio et l'énergie, et une durée.

4. Dispositif selon l'une quelconque des revendications précédentes, dans lequel une dose de bruit enregistrée est étiquetée avec un code d'incertitude représentant la manière dont l'estimation peut dévier de l'estimation complète de dose de bruit.

5. Dispositif selon l'une quelconque des revendications précédentes, dans lequel les données de dose de bruit de l'utilisateur enregistrées sur le dispositif comprennent des données de dose de bruit relatives à l'utilisateur, reçues à partir d'un serveur web.

6. Dispositif selon l'une quelconque des revendications précédentes, dans lequel le dispositif est apte à être connecté à une pluralité d'oreillettes différentes, le dispositif comprenant une pluralité de fichiers ou de paramètres d'étalonnage correspondant à des oreillettes respectives, où le fichier ou les paramètres d'étalonnage utilisés pour ajuster le niveau de sortie audio correspondent aux oreillettes.

7. Dispositif selon l'une quelconque des revendications 1 à 6, dans lequel les oreillettes sont identifiables sur le dispositif en entrant manuellement une identité unique des oreillettes sur le dispositif, ou dans lequel les oreillettes sont identifiables sur le dispositif en balayant un code-barres optique des oreillettes, tel qu'un code QR, tel qu'en balayant un emballage de produit ou similaire, tel qu'une carte de garantie, en utilisant une caméra incluse dans le dispositif programmable portable.

8. Dispositif selon l'une quelconque des revendications 1 à 7, dans lequel le fichier, le paramètre ou les paramètres d'étalonnage des oreillettes sont recevables sur le dispositif en balayant un code-barres optique du fichier, du paramètre ou des paramètres d'étalonnage, tel qu'un code QR, tel qu'en balayant un emballage de produit ou similaire, tel qu'une carte de garantie, en utilisant une caméra incluse dans le dispositif programmable portable.

9. Dispositif selon l'une quelconque des revendications précédentes, dans lequel l'ajustement du niveau de sortie audio est un ajustement du niveau de sortie audio en fonction de la fréquence audio.

10. Dispositif selon l'une quelconque des revendications précédentes, dans lequel le dispositif est configuré pour fournir des données de dose de bruit d'utilisateur en utilisant une connexion Internet à un site web comprenant un compte relatif à une exposition au bruit accumulée de l'utilisateur.

11. Dispositif selon l'une quelconque des revendications précédentes, dans lequel le dispositif est configuré pour présenter sur l'écran une estimation de la perte d'audition probable à une date future donnée ou à l'âge de l'utilisateur sur la base de la dose de bruit d'utilisateur enregistrée, ou dans lequel le dispositif est configuré pour démontrer l'effet probable de la perte d'audition sur la qualité d'audition, en réponse à une pression sur un bouton (par exemple, logiciel), ou dans lequel le dispositif comprend un réglage sélectionnable pour fournir une gestion automatique de dose d'audition.

12. Dispositif selon l'une quelconque des revendications précédentes, dans lequel le dispositif est configuré de telle sorte qu'un processus d'approximation logarithmique est utilisé pour comparer le rapport du signal à un seuil, qui conduit à un nombre proportionnel à un rapport logarithmique, et dans lequel des opérations de réponse ultérieures sont basées sur les dB, ou dans lequel le dispositif comprend des éléments de traitement de gestion de dose d'audition en cascade, dans lesquels il est fourni un signal sonore d'entrée, qui est fourni à un premier processeur de dose d'audition en cascade qui a une sortie allant vers un processeur de dose d'audition suivant ainsi qu'un signal contributif pour demander une atténuation, où les processus en cascade avec les signaux d'atténuation contributifs correspondants se combinent pour former un signal de commande d'atténuation global qui atténue le signal d'entrée dans une unité pour former un signal de sortie.

13. Dispositif selon l'une quelconque des revendications précédentes, dans lequel le dispositif est un téléphone intelligent.

14. Procédé d'ajustement du niveau de sortie audio sur un dispositif programmable portable, le dispositif comprenant une batterie, une mémoire et un terminal apte à être connecté à des oreillettes, le dispositif comprenant dans la mémoire un fichier, un paramètre ou des paramètres d'étalonnage concernant une sensibilité audio des oreillettes, le dispositif étant configuré pour lire des données multimédias comprenant de l'audio, le procédé comprenant les étapes suivantes :

(i) fournir une sortie audio aux oreillettes,
(ii) calculer, en utilisant le fichier, le paramètre ou les paramètres d'étalonnage, une dose de bruit relative à l'exposition au son d'un utilisateur résultant de la sortie audio fournie aux oreillettes ;
(iii) enregistrer la dose de bruit, et
(iv) ajuster le niveau de sortie audio en réponse :

(a) au contenu audio inclus dans les données multimédias lues ;
(b) au fichier, au paramètre ou aux paramètres d'étalonnage, et
(c) à des données de dose de bruit de l'utilisateur enregistrées sur le dispositif,

**caractérisé par** :
le dispositif invitant l'utilisateur à identifier les oreillettes lorsque les oreillettes sont connectées au dispositif, et
le calcul de la dose de bruit en utilisant un sous-échantillonnage à partir des signaux allant vers les oreillettes.

15. Produit programme d'ordinateur exécutable sur un dispositif programmable portable, le dispositif comprenant une batterie, une mémoire et un terminal apte à être connecté à des oreillettes, le produit programme d'ordinateur étant exécutable sur le dispositif pour ajuster le niveau de sortie audio, le dispositif comprenant dans la mémoire un fichier, un paramètre ou des paramètres d'étalonnage concernant une sensibilité audio des oreillettes, le dispositif étant configuré pour lire des données multimédias comprenant de l'audio, le produit programme d'ordinateur étant exécutable sur le dispositif pour :

(i) fournir une sortie audio aux oreillettes,
(ii) calculer, en utilisant le fichier, le paramètre ou les paramètres d'étalonnage, une dose de bruit relative à l'exposition sonore d'un utilisateur résultant de la sortie audio fournie aux oreillettes ;
(iii) enregistrer la dose de bruit, et
(iv) ajuster le niveau de sortie audio en réponse :

(a) au contenu audio inclus dans les données multimédias lues ;
(b) au fichier, au paramètre ou aux paramètres d'étalonnage, et
(c) à des données de dose de bruit de l'utilisateur enregistrées sur le dispositif,

**caractérisé par le fait que** le produit programme d'ordinateur est exécutable sur le dispositif pour :

inviter l'utilisateur à identifier les oreillettes lorsque les oreillettes sont connectées au dispositif, et
calculer la dose de bruit en utilisant un sous-échantillonnage à partir des signaux allant vers les oreillettes.

FIGURE 1

FIGURE 2

EP 3 220 821 B1

FIGURE 3

305

304

302

317

320

319

321

318

306

EP 3 220 821 B1

FIGURE 4

EP 3 220 821 B1

FIGURE 5

601 602 603

FIGURE 6  PRIOR ART

EP 3 220 821 B1

701    702    703

706    707

704

705

FIGURE 7

EP 3 220 821 B1

801    802    803

806

804

805

EP 3 220 821 B1

FIGURE 8

EP 3 220 821 B1

901

902

903

904

905

FIGURE 9

FIGURE 10

EP 3 220 821 B1

FIGURE 11

114

101

115

109

113

112

120

121

FIGURE 12

**EP 3 220 821 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008137873 A1
- US 20100027807 A1
- US 20090315708 A1
- US 20120051555 A1
- US 20120057726 A1
- WO 2008136723 A1
- WO 2011050401 A1
- US 20070274531 A1
- US 20080181424 A1
- US 20080130906 A1